# EUROPEAN PATENT APPLICATION

(11) **EP 4 769 409 A1**
(43) Date of publication of application: **01.07.2026**
(21) Application number: 24856140.9
(22) Date of filing: 01.07.2024
(51) Int. Cl.: G11C 14/00, G11C 11/412

(54) **SEMICONDUCTOR CIRCUIT AND DRIVING METHOD**

(30) Priority: 24.08.2023 JP 2023136263
(71) Applicant: Sony Semiconductor Solutions Corporation, Atsugi-shi, Kanagawa 243-0014 (JP)
(72) Inventor: TSUKAMOTO, Masanori, Atsugi-shi, Kanagawa 243-0014 (JP)
(74) Representative: MFG Patentanwälte Meyer-Wildhagen Meggle-Freund Gerhard PartG mbB
(86) International application number: PCT/JP2024/023739
(87) International publication number: WO 2025/041445

(57) **Abstract**

A semiconductor circuit according to one embodiment of the present disclosure includes: a first inverter configured to apply an inverted voltage of a voltage at a first node to a second node; a second inverter configured to apply an inverted voltage of a voltage at the second node to the first node; first and second bit lines; a first transistor provided on a path coupling the first bit line and the first node to each other; a second transistor provided on a path coupling the second bit line and the second node to each other; first and second control lines; a first ferroelectric capacitor provided on a path coupling the first control line and the first node to each other; a second ferroelectric capacitor provided on a path coupling the second control line and the second node to each other; a third transistor including a gate coupled to the second node; a first signal line; and a fourth transistor provided on a path coupling the first signal line and the third transistor to each other.

## Description

### Technical Field

The present disclosure relates to a semiconductor circuit that stores data, and to a drive method thereof.

### Background Art

Data is often stored in a semiconductor circuit. For example, Non-Patent Literature 1 discloses a technique to achieve improvement in read disturb by adding two transistors for a read operation to a memory cell of an SRAM (Static Random Access Memory).

### Citation List

### Non-Patent Literature

NPTL 1: Leland Chang, et al., "Stable SRAM Cell Design for the 32 nm Node and Beyond", p. 129, 2005 Symposium on VLSI Technology

### Summary of the Invention

What is desired of a circuit that stores data is to allow data to be stored stably by preventing an easy occurrence of a read disturb and a write disturb.

It is desirable to provide a semiconductor circuit and a drive method thereof that each make it possible to store data stably.

A semiconductor circuit according to one embodiment of the present disclosure includes a first inverter, a second inverter, a first bit line and a second bit line, a first transistor, a second transistor, a first control line and a second control line, a first ferroelectric capacitor, a second ferroelectric capacitor, a third transistor, a first signal line, and a fourth transistor. The first inverter is configured to generate an inverted voltage of a voltage at a first node and configured to apply the inverted voltage to a second node. The second inverter is configured to generate an inverted voltage of a voltage at the second node and configured to apply the inverted voltage to the first node. The first transistor is provided on a path coupling the first bit line and the first node to each other. The second transistor is provided on a path coupling the second bit line and the second node to each other. The first ferroelectric capacitor is provided on a path coupling the first control line and the first node to each other. The second ferroelectric capacitor is provided on a path coupling the second control line and the second node to each other. The third transistor includes a gate, a source, and a drain, the gate being coupled to the second node. The fourth transistor is provided on a path coupling the first signal line and one of the source and the drain of the third transistor to each other.

A drive method according to one embodiment of the present disclosure includes performing a first drive operation on a semiconductor circuit, performing a second drive operation on the semiconductor circuit, and performing a third drive operation on the semiconductor circuit. The semiconductor circuit includes: a first inverter configured to generate an inverted voltage of a voltage at a first node and configured to apply the inverted voltage to a second node; a second inverter configured to generate an inverted voltage of a voltage at the second node and configured to apply the inverted voltage to the first node; a first bit line and a second bit line; a first transistor provided on a path coupling the first bit line and the first node to each other; a second transistor provided on a path coupling the second bit line and the second node to each other; a first control line and a second control line; a first ferroelectric capacitor provided on a path coupling the first control line and the first node to each other; a second ferroelectric capacitor provided on a path coupling the second control line and the second node to each other; a third transistor including a gate, a source, and a drain, the gate being coupled to the second node; a first signal line; and a fourth transistor provided on a path coupling the first signal line and one of the source and the drain of the third transistor to each other. The first drive operation includes: bringing the first transistor and the second transistor into an ON state; applying one of an active voltage and a ground voltage to the first bit line and the second control line; and applying another of the active voltage and the ground voltage to the second bit line and the first control line. The second drive operation includes: bringing the first transistor and the second transistor into an OFF state; applying the ground voltage to the first control line and the second control line; and stopping power supply to the first inverter and the second inverter. The third drive operation includes: bringing the first transistor and the second transistor into the OFF state; applying the ground voltage to the first control line and the second control line; and performing the power supply to the first inverter and the second inverter.

In the semiconductor circuit according to one embodiment of the present disclosure, the inverted voltage of the voltage at the first node is applied to the second node by the first inverter, and the inverted voltage of the voltage at the second node is applied to the first node by the second inverter. The first transistor is provided on the path coupling the first bit line and the first node to each other, and the second transistor is provided on the path coupling the second bit line and the second node to each other. Further, the first ferroelectric capacitor is provided on the path coupling the first control line and the first node to each other, and the second ferroelectric capacitor is provided on the path coupling the second control line and the second node to each other. The second node is coupled to the gate of the third transistor. The fourth transistor is provided on the path coupling the first signal line and one of the source and the drain of the third transistor to each other.

In the drive method according to one embodiment of the present disclosure, the first drive operation, the second drive operation, and the third drive operation are performed on the semiconductor circuit described above. In the first drive operation, the first transistor and the second transistor are brought into the ON state, one of the active voltage and the ground voltage is applied to the first bit line and the second control line, and the other of the active voltage and the ground voltage is applied to the second bit line and the first control line. In the second drive operation, the first transistor and the second transistor are brought into the OFF state, the ground voltage is applied to the first control line and the second control line, and power supply to the first inverter and the second inverter is stopped. In the third drive operation, the first transistor and the second transistor are brought into the OFF state, the ground voltage is applied to the first control line and the second control line, and the power supply to the first inverter and the second inverter is performed.

### Brief Description of Drawings

[FIG. 1] FIG. 1 is a block diagram illustrating a configuration example of a semiconductor circuit according to a first embodiment of the present disclosure.
[FIG. 2] FIG. 2 is a circuit diagram illustrating a configuration example of a memory cell illustrated in FIG. 1.
[FIG. 3] FIG. 3 is a characteristic diagram illustrating a characteristic example of a ferroelectric capacitor illustrated in FIG. 2.
[FIG. 4] FIG. 4 is a table illustrating an example of a write operation of the semiconductor circuit illustrated in FIG. 1.
[FIG. 5] FIG. 5 is an explanatory diagram illustrating an operation state in the write operation illustrated in FIG. 4.
[FIG. 6] FIG. 6 is an explanatory diagram illustrating another operation state in the write operation illustrated in FIG. 4.
[FIG. 7] FIG. 7 is an explanatory diagram illustrating another operation state in the write operation illustrated in FIG. 4.
[FIG. 8A] FIG. 8A is an explanatory diagram illustrating an operation state in an operation illustrated in FIG. 7.
[FIG. 8B] FIG. 8B is an explanatory diagram illustrating an example of an operating point of the ferroelectric capacitor in an operation illustrated in FIG. 8A.
[FIG. 9A] FIG. 9A is an explanatory diagram illustrating another operation state in the operation illustrated in FIG. 7.
[FIG. 9B] FIG. 9B is an explanatory diagram illustrating an example of the operating point of the ferroelectric capacitor in an operation illustrated in FIG. 9A.
[FIG. 10A] FIG. 10A is an explanatory diagram illustrating another operation state in the operation illustrated in FIG. 7.
[FIG. 10B] FIG. 10B is an explanatory diagram illustrating an example of the operating point of the ferroelectric capacitor in an operation illustrated in FIG. 10A.
[FIG. 11A] FIG. 11A is an explanatory diagram illustrating an operation state in the write operation of the semiconductor circuit illustrated in FIG. 1.
[FIG. 11B] FIG. 11B is an explanatory diagram illustrating another operation state in the write operation of the semiconductor circuit illustrated in FIG. 1.
[FIG. 11C] FIG. 11C is an explanatory diagram illustrating another operation state in the write operation of the semiconductor circuit illustrated in FIG. 1.
[FIG. 11D] FIG. 11D is an explanatory diagram illustrating another operation state in the write operation of the semiconductor circuit illustrated in FIG. 1.
[FIG. 12] FIG. 12 is a table illustrating an example of a read operation and a standby operation of the semiconductor circuit illustrated in FIG. 1.
[FIG. 13] FIG. 13 is an explanatory diagram illustrating an operation state in the read operation illustrated in FIG. 12.
[FIG. 14] FIG. 14 is an explanatory diagram illustrating an operation state in the standby operation illustrated in FIG. 12.
[FIG. 15] FIG. 15 is a table illustrating an example of a store operation of the semiconductor circuit illustrated in FIG. 1.
[FIG. 16A] FIG. 16A is an explanatory diagram illustrating an operation state in the store operation illustrated in FIG. 15.
[FIG. 16B] FIG. 16B is an explanatory diagram illustrating another operation state in the store operation illustrated in FIG. 15.
[FIG. 17] FIG. 17 is a table illustrating an example of the write operation of a semiconductor circuit according to a modification example of the first embodiment.
[FIG. 18] FIG. 18 is an explanatory diagram illustrating an operation state in the write operation illustrated in FIG. 17.
[FIG. 19] FIG. 19 is a block diagram illustrating a configuration example of a semiconductor circuit according to a second embodiment.
[FIG. 20] FIG. 20 is a circuit diagram illustrating a configuration example of a memory cell illustrated in FIG. 19.
[FIG. 21] FIG. 21 is a block diagram illustrating an operation example of the semiconductor circuit illustrated in FIG. 19.
[FIG. 22] FIG. 22 is a block diagram illustrating an operation example of a semiconductor circuit according to a modification example of the second embodiment.
[FIG. 23] FIG. 23 is a circuit diagram illustrating a configuration example of a memory cell array illustrated in FIG. 22.
[FIG. 24] FIG. 24 is a circuit diagram illustrating a configuration example of a memory cell according to a modification example of the second embodiment.
[FIG. 25] FIG. 25 is a circuit diagram illustrating a configuration example of a memory cell according to another modification example of the second embodiment.

### Modes for Carrying Out the Invention

In the following, some embodiments of the present disclosure are described in detail with reference to the drawings. It is to be noted that description is given in the following order.
1. First Embodiment
2. Second Embodiment

### <1. First Embodiment>

### [Configuration Example]

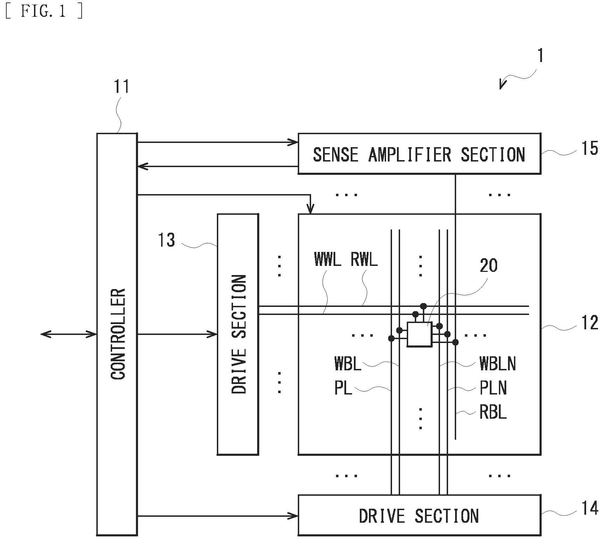

FIG. 1 illustrates a configuration example of a semiconductor circuit (a semiconductor circuit 1) according to a first embodiment. The semiconductor circuit 1 is a circuit that stores data. The semiconductor circuit 1 includes a controller 11, a memory cell array 12, drive sections 13 and 14, and a sense amplifier section 15.

The controller 11 is configured to control an operation of the semiconductor circuit 1 by controlling operations of the memory cell array 12, the drive sections 13 and 14, and the sense amplifier section 15. Specifically, the controller 11 controls the operation of the semiconductor circuit 1 to cause data to be written into the memory cell array 12 on the basis of a write command and write data supplied from the outside, and to cause data to be read from the memory cell array 12 on the basis of a read command supplied from the outside. Further, the controller 11 controls a power supply voltage of each circuit in the semiconductor circuit 1 depending on the operation.

The memory cell array 12 includes a plurality of memory cells 20, a plurality of write word lines WWL, a plurality of read word lines RWL, a plurality of write bit lines WBL, a plurality of write bit lines WBLN, a plurality of read bit lines RBL, a plurality of control lines PL, and a plurality of control lines PLN.

Each of the plurality of memory cells 20 is configured to store data. The plurality of memory cells 20 is disposed in a matrix. The memory cells 20 are coupled to the write word lines WWL, the read word lines RWL, the write bit lines WBL and WBLN, the read bit lines RBL, and the control lines PL and PLN.

The write word lines WWL extend in a horizontal direction in FIG. 1, and one end of each of the write word lines WWL is coupled to the drive section 13. The read word lines RWL extend in the horizontal direction in FIG. 1, and one end of each of the read word lines RWL is coupled to the drive section 13. The write bit lines WBL extend in a vertical direction in FIG. 1, and one end of each of the write bit lines WBL is coupled to the drive section 14. The write bit lines WBLN extend in the vertical direction in FIG. 1, and one end of each of the write bit lines WBLN is coupled to the drive section 14. The read bit lines RBL extend in the vertical direction in FIG. 1, and one end of each of the read bit lines RBL is coupled to the sense amplifier section 15. The control lines PL extend in the vertical direction in FIG. 1, and one end of each of the control lines PL is coupled to the drive section 14. The control lines PLN extend in the vertical direction in FIG. 1, and one end of each of the control lines PLN is coupled to the drive section 14.

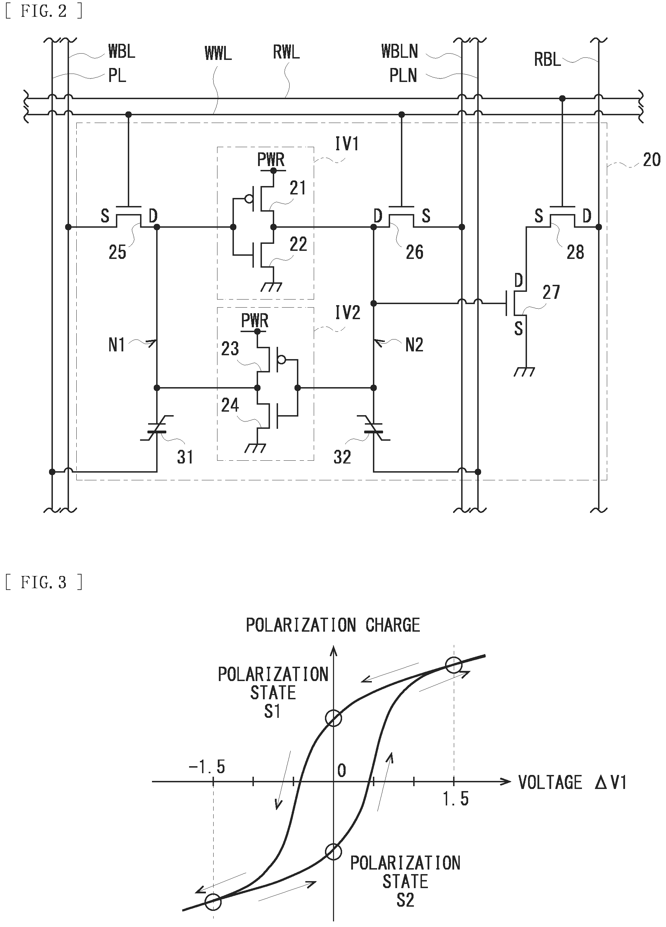

FIG. 2 illustrates a configuration example of the memory cell 20. The memory cell 20 includes transistors 21 to 28 and ferroelectric capacitors 31 and 32.

The transistors 21 and 23 are P-type MOS (Metal Oxide Semiconductor) transistors, and the transistors 22 and 24 are N-type MOS transistors. The transistor 21 has a gate coupled to a node N1, a source coupled to a power supply node PWR, and a drain coupled to a node N2. The transistor 22 has a gate coupled to the node N1, a source grounded, and a drain coupled to the node N2. The transistors 21 and 22 configure an inverter IV1. The inverter IV1 inverts a voltage at the node N1 and outputs a result of the inversion to the node N2. The transistor 23 has a gate coupled to the node N2, a source coupled to the power supply node PWR, and a drain coupled to the node N1. The transistor 24 has a gate coupled to the node N2, a source grounded, and a drain coupled to the node N1. The transistors 23 and 24 configure an inverter IV2. The inverter IV2 inverts a voltage at the node N2 and outputs a result of the inversion to the node N1.

This configuration couples an input terminal of the inverter IV1 and an output terminal of the inverter IV2 to each other through the node N1, and couples an input terminal of the inverter IV2 and an output terminal of the inverter IV1 to each other through the node N2. This causes a circuit including the inverters IV1 and IV2 to retain one-bit data by positive feedback. In this way, the circuit including the inverters IV1 and IV2 serves as a retention circuit that retains one-bit data.

The transistors 25 to 28 are N-type MOS transistors. The transistor 25 has a gate coupled to the write word line WWL, a source coupled to the write bit line WBL, and a drain coupled to the node N1. The transistor 26 has a gate coupled to the write word line WWL, a source coupled to the write bit line WBLN, and a drain coupled to the node N2. The transistor 27 has a gate coupled to the node N2, a source grounded, and a drain coupled to a source of the transistor 28. The transistor 28 has a gate coupled to the read word line RWL, the source coupled to the drain of the transistor 27, and a drain coupled to the read bit line RBL.

The ferroelectric capacitors 31 and 32 are capacitors including a ferroelectric material, and are nonvolatile storage elements that store data through the use of a polarization state of the ferroelectric. The ferroelectric capacitor 31 has one end coupled to the node N1 and another end coupled to the control line PL. The ferroelectric capacitor 32 has one end coupled to the node N2 and another end coupled to the control line PLN.

FIG. 3 illustrates an operation example of the ferroelectric capacitor 31. A horizontal axis represents a voltage ΔV1 across the ferroelectric capacitor 31, and a vertical axis represents polarization charge in the ferroelectric capacitor 31. The voltage ΔV1 is a voltage at the node N1 with respect to that at the control line PL.

The ferroelectric capacitor 31 may take either of two polarization states S1 and S2. The polarization state S1 is a state (a positive state) in which the polarization charge is positive charge. The polarization state S2 is a state (a negative state) in which the polarization charge is negative charge.

For example, in a case where the polarization state of the ferroelectric capacitor 31 is the polarization state S2, changing the voltage ΔV1 from "0 V" to "1.5 V" causes the polarization charge to change from the negative charge to the positive charge in response to the change in the voltage ΔV1. Then, when the voltage ΔV1 becomes about "1.5 V", for example, the polarization state changes to the polarization state S1 (the positive state). Thereafter, when the voltage ΔV1 is changed back to "0 V" from "1.5 V", the polarization charge slightly changes but remains being the positive charge. In such a manner, the polarization state of the ferroelectric capacitor 31 comes into the polarization state S1.

For example, in a case where the polarization state of the ferroelectric capacitor 31 is the polarization state S1, changing the voltage ΔV1 from "0 V" to "-1.5 V" causes the polarization charge to change from the positive charge to the negative charge in response to the change in the voltage ΔV1. Then, when the voltage ΔV1 becomes about "-1.5 V", for example, the polarization state changes to the polarization state S2 (the negative state). Thereafter, when the voltage ΔV1 is changed back to "0 V" from "-1.5 V", the polarization charge slightly changes but remains being the negative charge. In such a manner, the polarization state of the ferroelectric capacitor 31 comes into the polarization state S2.

As described above, in this example, setting the voltage ΔV1 of the ferroelectric capacitor 31 to "1.5 V" causes the polarization state of the ferroelectric capacitor 31 to be the polarization state S1, and setting the voltage ΔV1 of the ferroelectric capacitor 31 to "-1.5 V" causes the polarization state of the ferroelectric capacitor 31 to be the polarization state S2. As illustrated in FIG. 3, a characteristic of the ferroelectric capacitor 31 exhibits a hysteresis characteristic. Although the description has been given above of the operation of the ferroelectric capacitor 31 as an example, the above description similarly applies to the ferroelectric capacitor 32, and the polarization state of the ferroelectric capacitor 32 changes in accordance with a voltage ΔV2 across the ferroelectric capacitor 32. The voltage ΔV2 is a voltage at the node N2 with respect to that at the control line PLN. In the ferroelectric capacitors 31 and 32, data is to be stored through the use of such polarization states.

As described above, the memory cell 20 includes the eight transistors 21 to 28 and the two ferroelectric capacitors 31 and 32. With such a configuration, in a write operation in the memory cell 20, first, data is written into the ferroelectric capacitors 31 and 32 through the transistors 25 and 26, and thereafter, the data having been written into the ferroelectric capacitors 31 and 32 is written into the circuit including the inverters IV1 and IV2. Further, in a read operation in the memory cell 20, the data having been written into the circuit including the inverters IV1 and IV2 is read through the transistor 28.

The drive section 13 (FIG. 1) is coupled to the plurality of write word lines WWL and the plurality of read word lines RWL of the memory cell array 12, and is configured to apply a signal to the write word lines WWL and the read word lines RWL of the memory cell array 12 on the basis of a control signal supplied from the controller 11.

The drive section 14 is coupled to the plurality of write bit lines WBL, the plurality of write bit lines WBLN, the plurality of control lines PL, and the plurality of control lines PLN of the memory cell array 12, and is configured to apply a signal to the write bit lines WBL and WBLN and the control lines PL and PLN of the memory cell array 12 on the basis of a control signal supplied from the controller 11.

The sense amplifier section 15 is coupled to the plurality of read bit lines RBL of the memory cell array 12, and is configured to read data from the memory cell array 12 through the read bit lines RBL and supply the data having been read to the controller 11, on the basis of a control signal supplied from the controller 11.

Here, the inverter IV1 corresponds to a specific example of a "first inverter" in one embodiment of the present disclosure. The inverter IV2 corresponds to a specific example of a "second inverter" in one embodiment of the present disclosure. The node N1 corresponds to a specific example of a "first node" in one embodiment of the present disclosure. The node N2 corresponds to a specific example of a "second node" in one embodiment of the present disclosure. The write bit line WBL corresponds to a specific example of a "first bit line" in one embodiment of the present disclosure. The write bit line WBLN corresponds to a specific example of a "second bit line" in one embodiment of the present disclosure. The transistor 25 corresponds to a specific example of a "first transistor" in one embodiment of the present disclosure. The transistor 26 corresponds to a specific example of a "second transistor" in one embodiment of the present disclosure. The control line PL corresponds to a specific example of a "first control line" in one embodiment of the present disclosure. The control line PLN corresponds to a specific example of a "second control line" in one embodiment of the present disclosure. The ferroelectric capacitor 31 corresponds to a specific example of a "first ferroelectric capacitor" in one embodiment of the present disclosure. The ferroelectric capacitor 32 corresponds to a specific example of a "second ferroelectric capacitor" in one embodiment of the present disclosure. The transistor 27 corresponds to a specific example of a "third transistor" in one embodiment of the present disclosure. The read bit line RBL corresponds to a specific example of a "first signal line" in one embodiment of the present disclosure. The transistor 28 corresponds to a specific example of a "fourth transistor" in one embodiment of the present disclosure. The drive sections 13 and 14 each correspond to a specific example of a "drive section" in one embodiment of the present disclosure. The sense amplifier section 15 corresponds to a specific example of a "read section" in one embodiment of the present disclosure. The power supply node PWR corresponds to a specific example of a "power supply node" in one embodiment of the present disclosure.

### [Operations and Workings]

Next, a description will be given of operations and workings of the semiconductor circuit 1 according to the present embodiment.

### (Outline of Overall Operation)

First, a description will be given of an outline of an overall operation of the semiconductor circuit 1 with reference to FIGs. 1 and 2. The controller 11 controls the operation of the semiconductor circuit 1 by controlling the operations of the memory cell array 12, the drive sections 13 and 14, and the sense amplifier section 15. Each of the plurality of memory cells 20 in the memory cell array 12 stores data. The drive section 13 applies a signal to the write word lines WWL and the read word lines RWL of the memory cell array 12 on the basis of the control signal supplied from the controller 11. The drive section 14 applies a signal to the write bit lines WBL and WBLN and the control lines PL and PLN of the memory cell array 12 on the basis of the control signal supplied from the controller 11. The sense amplifier section 15 reads data from the memory cell array 12 through the read bit lines RBL and supplies the data having been read to the controller 11 on the basis of the control signal supplied from the controller 11.

### (Detailed Operation)

Next, a detailed description will be given of a write operation OP1, a read operation OP2, a standby operation OP3, and a store operation OP4.

### (Write Operation OP1)

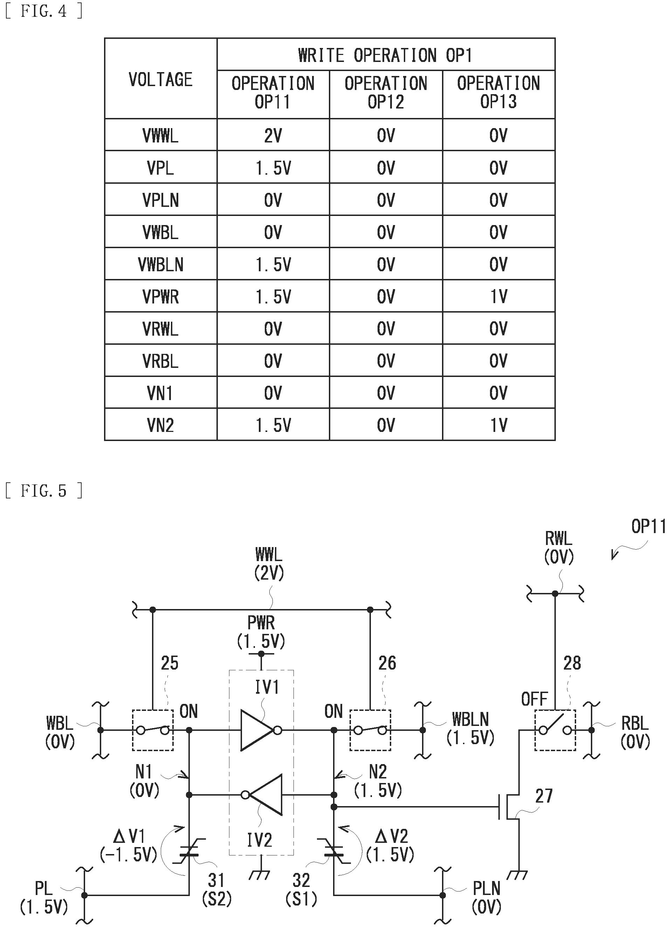

FIG. 4 illustrates an example of the write operation OP1 on the memory cell 20 for data. The write operation OP1 is an operation to write data into the memory cell 20. The write operation OP1 includes three operations OP11 to OP13. The operation OP11 is an operation to cause the ferroelectric capacitors 31 and 32 of the memory cell 20 to store data. The operation OP12 is an operation to temporarily stop electric power supply to the inverters IV1 and IV2. The operation OP13 is an operation to resume the electric power supply to the inverters IV1 and IV2 and to transfer the data stored in the ferroelectric capacitors 31 and 32 to the retention circuit including the inverters IV1 and IV2. FIG. 4 illustrates a voltage VWWL of the write word line WWL, a voltage VPL of the control line PL, a voltage VPLN of the control line PLN, a voltage VWBL of the write bit line WBL, a voltage VWBLN of the write bit line WBLN, a voltage VPWR of the power supply node PWR, a voltage VRWL of the read word line RWL, a voltage VRBL of the read bit line RBL, a voltage VN1 of the node N1, and a voltage VN2 of the node N2 in each of the operations OP11 to OP13.

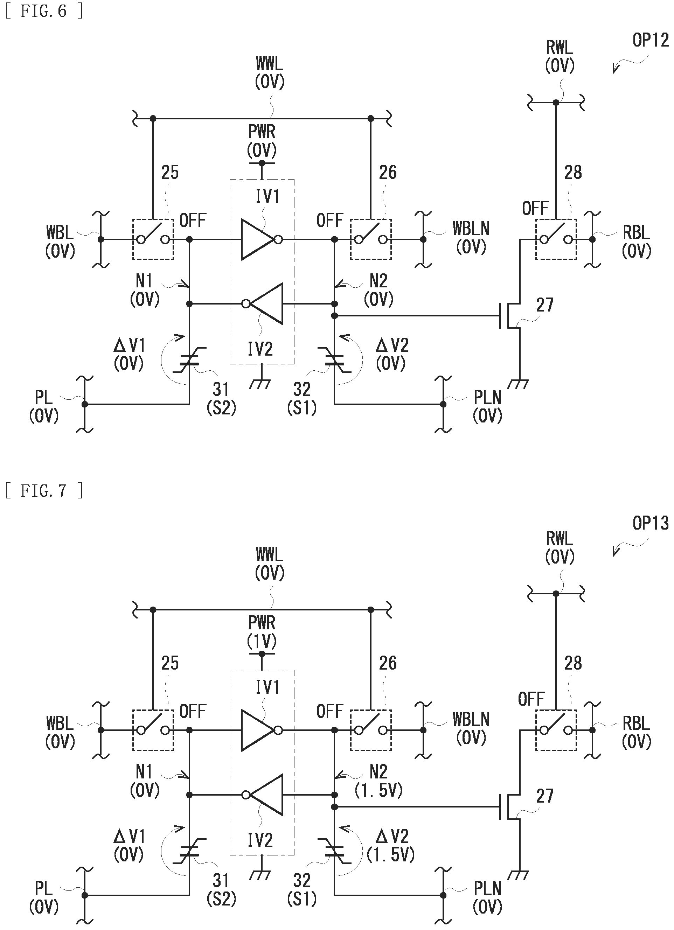

FIG. 5 illustrates an example of the operation OP11. FIG. 6 illustrates an example of the operation OP12. FIG. 7 illustrates an example of the operation OP13. In FIGs. 5 to 7, a symbol of an inverter is used to represent each of the inverters IV1 and IV2, and a symbol of a switch indicating an ON or OFF state is used to represent each of the transistors 25, 26, and 28. In the operations OP11 to OP13, the drive section 13 sets the voltage VRWL of the read word line RWL to "0 V", and the sense amplifier section 15 sets the voltage VRBL of the read bit line RBL to "0 V". This causes the transistor 28 to remain in the OFF state.

First, the semiconductor circuit 1 performs the operation OP11 to thereby cause the ferroelectric capacitors 31 and 32 of the memory cell 20 to store data (FIG. 5). Specifically, first, the drive section 13 sets the voltage VWWL of the write word line WWL to "2 V". This brings the transistors 25 and 25 into the ON state. Then, the drive section 14 sets the voltage VWBL of the write bit line WBL to "0 V" and sets the voltage VWBLN of the write bit line WBLN to "1.5 V". This sets the voltage VN1 of the node N1 to "0 V" and sets the voltage VN2 of the node N2 to "1.5 V". Further, the drive section 14 sets the voltage VPL of the control line PL to "1.5 V" and sets the voltage VPLN of the control line PLN to "0 V". This sets the voltage ΔV1 of the ferroelectric capacitor 31 to "-1.5 V" and sets the voltage ΔV2 of the ferroelectric capacitor 32 to "1.5 V". As a result, the polarization state of the ferroelectric capacitor 31 becomes the polarization state S2 (the negative state), and the polarization state of the ferroelectric capacitor 32 becomes the polarization state S1 (the positive state).

Next, the semiconductor circuit 1 performs the operation OP12 to thereby temporarily stop electric power supply to the inverters IV1 and IV2 of the memory cell 20 (FIG. 6). Specifically, first, the drive section 13 sets the voltage VWWL of the write word line WWL to "0 V". This brings the transistors 25 and 26 into the OFF state. Then, the drive section 14 sets the voltage VWBL of the write bit line WBL, the voltage VWBLN of the write bit line WBLN, the voltage VPL of the control line PL, and the voltage VPLN of the control line PLN to "0 V". Then, the controller 11 sets the voltage VPWR of the power supply node PWR to "0 V". The polarization state of the ferroelectric capacitor 31 is maintained as the polarization state S2, and the polarization state of the ferroelectric capacitor 32 is maintained as the polarization state S1.

Next, the semiconductor circuit 1 performs the operation OP13 to thereby transfer the data stored in the ferroelectric capacitors 31 and 32 to the retention circuit including the inverters IV1 and IV2 (FIG. 7). Specifically, first, the drive section 13 sets the voltage VWWL of the write word line WWL to "0 V". This brings the transistors 25 and 26 into the OFF state. Further, the drive section 14 sets the voltage VWBL of the write bit line WBL, the voltage VWBLN of the write bit line WBLN, the voltage VPL of the control line PL, and the voltage VPLN of the control line PLN to "0 V". Then, the controller 11 changes the voltage VPWR of the power supply node PWR from "0 V" to "1 V". This causes the voltages VN1 and VN2 of the nodes N1 and N2 to change to respective voltages corresponding to the polarization states of the ferroelectric capacitors 31 and 32.

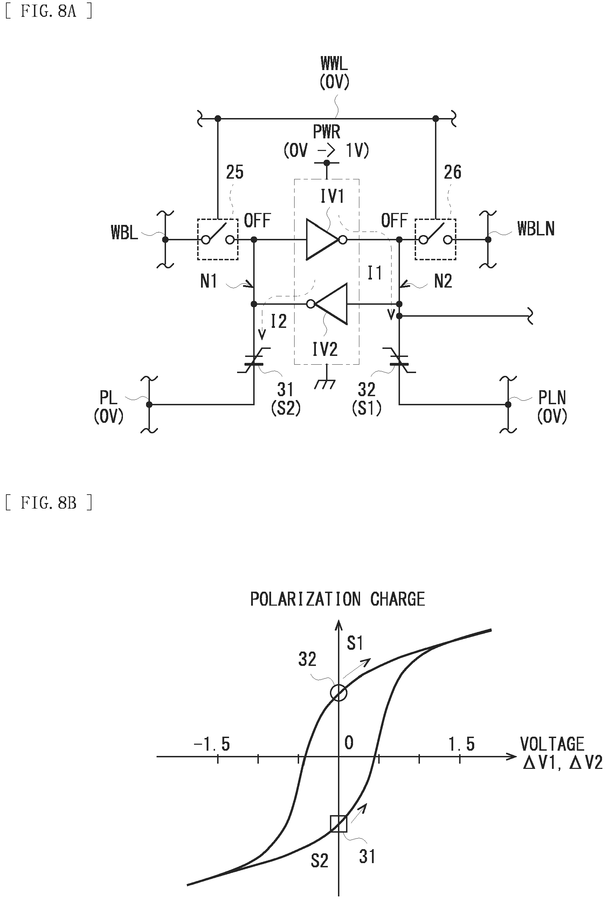

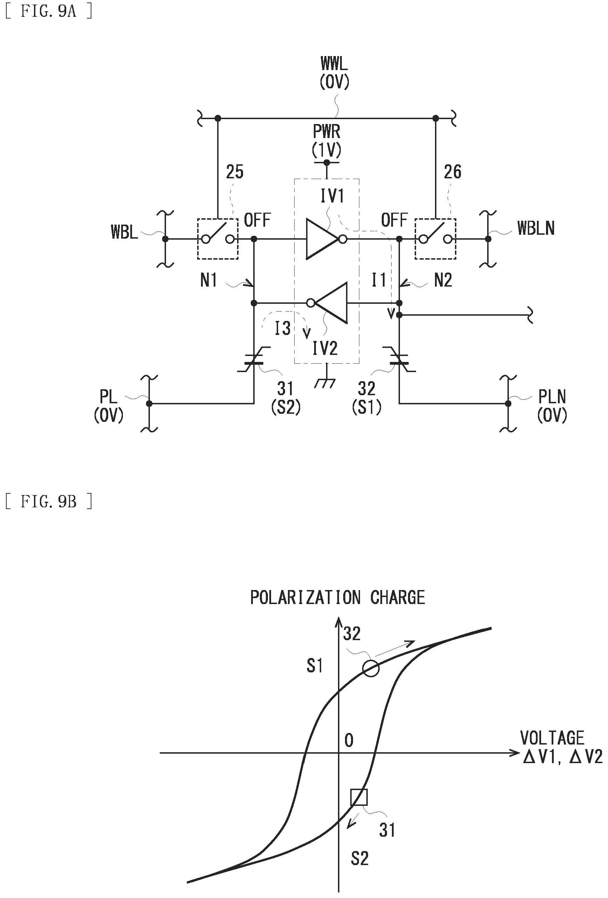

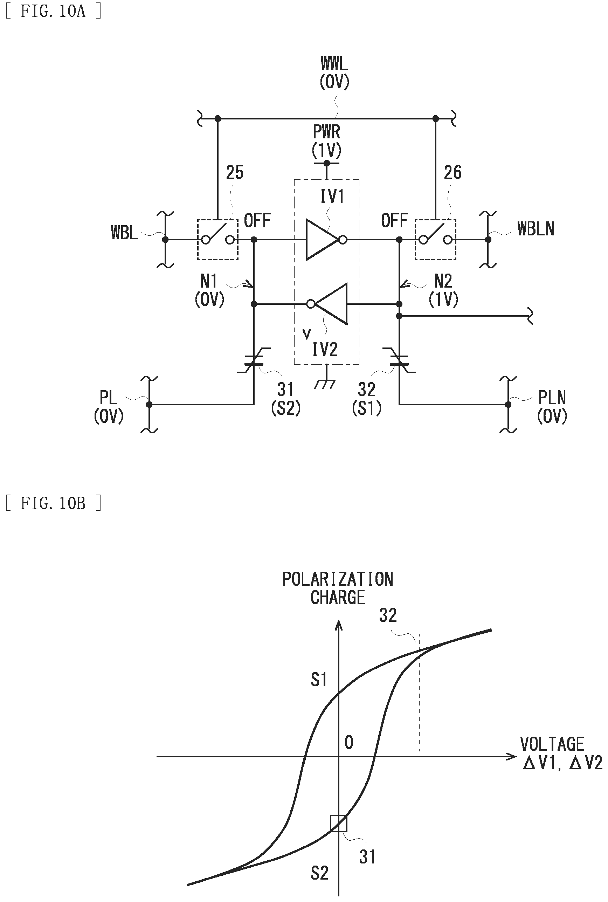

FIGs. 8A, 8B, 9A, 9B, 10A, and 10B illustrate an example of detailed operations in the operation OP13. In the operation OP13, the memory cell 20 changes in state to a state illustrated in FIGs. 8A and 8B, to a state illustrated in FIGs. 9A and 9B, and to a state illustrated in FIGs. 10A and 10B in this order. In FIGs. 8B, 9B, and 10B, a square symbol indicates an operating point of the ferroelectric capacitor 31, and a circular symbol indicates an operating point of the ferroelectric capacitor 32. It is to be noted that in FIGs. 8A, 8B, and 8C, illustrations of the read word lines RWL, the read bit lines RBL, and the transistors 27 and 28 are omitted.

First, as illustrated in FIG. 8A, the voltage of the power supply node PWR changes from "0 V" to "1 V". Because the voltage VN1 of the node N1 and the voltage VN2 of the node N2 are initially "0 V", the transistor 21 of the inverter IV1 and the transistor 23 of the inverter IV2 change from the OFF state to the ON state due to a rise in voltage of the power supply node PWR. This causes a current I1 to flow from the power supply node PWR toward the node N2 through the transistor 21 of the inverter IV1, and causes a current I2 to flow from the power supply node PWR toward the node N1 through the transistor 23 of the inverter IV2, which in turn causes the voltage VN1 of the node N1 and the voltage VN2 of the node N2 to rise. Accordingly, the voltages ΔV1 and ΔV2 of the ferroelectric capacitors 31 and 32 rise, and therefore, as illustrated in FIG. 8B, the operating point of the ferroelectric capacitor 31 moves rightward along a characteristic line of the polarization state S2 of the ferroelectric capacitor 31, and the operating point of the ferroelectric capacitor 32 moves rightward along a characteristic line of the polarization state S1 of the ferroelectric capacitor 32.

As illustrated in FIG. 8B, a change of the polarization charge when the operating point of the ferroelectric capacitor 32 changes is smaller than a change of the polarization charge when the operating point of the ferroelectric capacitor 31 changes. This means that a capacitance across the ferroelectric capacitor 32 is smaller than a capacitance across the ferroelectric capacitor 31. Accordingly, the voltage VN2 of the node N2 to which the ferroelectric capacitor 32 is coupled rises faster than the voltage VN1 of the node N1 to which the ferroelectric capacitor 31 is coupled.

When the voltage VN2 of the node N2 rises, the transistor 23 of the inverter IV2 changes from the ON state to the OFF state, and the transistor 24 changes from the OFF state to the ON state. This causes, as illustrated in FIG. 9A, a current I3 to flow from the node N1 toward a ground node through the transistor 24 of the inverter IV2. This causes the voltage VN1 of the node N1 to drop. In such a manner, the voltage VN2 of the node N2 rises, and the voltage VN1 of the node N1 drops. As a result, the voltage ΔV1 of the ferroelectric capacitor 31 drops and the voltage ΔV2 of the ferroelectric capacitor 32 rises, and therefore, as illustrated in FIG. 9B, the operating point of the ferroelectric capacitor 31 moves leftward along the characteristic line of the polarization state S2 of the ferroelectric capacitor 31, and the operating point of the ferroelectric capacitor 32 moves rightward along the characteristic line of the polarization state S1 of the ferroelectric capacitor 32.

In such a manner, the voltage VN2 of the node N2 rises, and the voltage VN1 of the node N1 drops. Then, finally, as illustrated in FIG. 10A, the voltage VN1 of the node N1 becomes "1 V", and the voltage VN2 of the node N2 becomes "0 V". As illustrated in FIG. 10B, the voltage ΔV1 of the ferroelectric capacitor 31 is "0 V", and the voltage ΔV2 of the ferroelectric capacitor 32 is "1 V".

In this way, the semiconductor circuit 1 performs the operation OP11 to cause the ferroelectric capacitors 31 and 32 of the memory cell 20 to store data, performs the operation OP12 to temporarily stop the electric power supply to the inverters IV1 and IV2, and performs the operation OP13 to resume the electric power supply to the inverters IV1 and IV2 and to transfer the data stored in the ferroelectric capacitors 31 and 32 to the retention circuit including the inverters IV1 and IV2. This makes it possible for the semiconductor circuit 1 to prevent an easy occurrence of a write disturb, as indicated below.

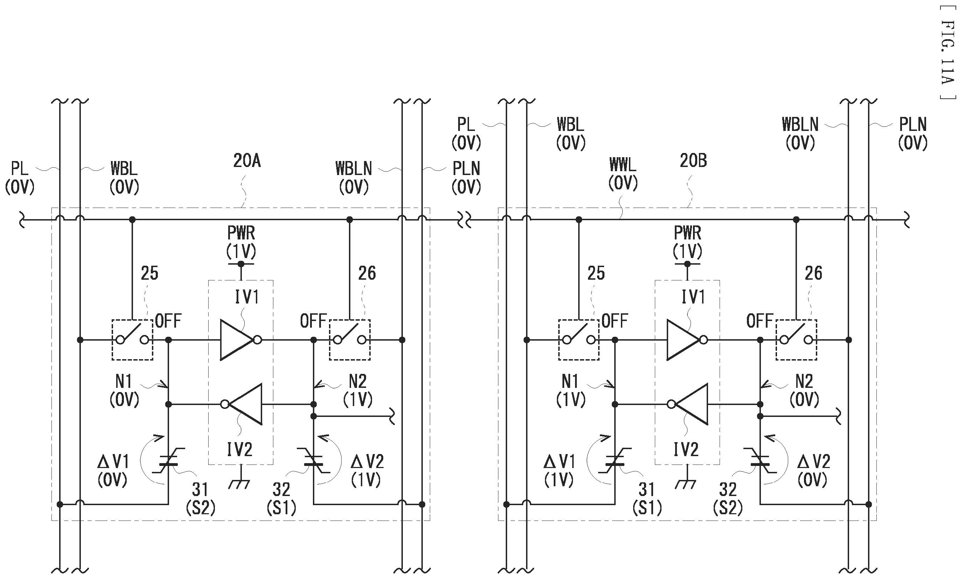

FIGs. 11A to 11D illustrate an example of data write operation of the memory cell array 12. These FIGs. 11A to 11D illustrate two memory cells 20 (memory cells 20A and 20B). These two memory cells 20A and 20B belong to the same row, and are coupled to one write word line WWL and one read word line RWL. It is to be noted that in FIGs. 11A to 11D, illustrations of the read word lines RWL, the read bit lines RBL, and the transistors 27 and 28 are omitted.

In this example, data writing is performed on the memory cell 20B, and no data writing is performed on the memory cell 20A. Accordingly, the semiconductor circuit 1 performs the operations OP11 to OP13 for the memory cell 20B.

As illustrated in FIG. 11A, immediately before the write operation, the write word line WWL coupled to the memory cells 20A and 20B has a voltage of "0 V" in this example. Accordingly, the transistors 25 and 26 of each of the memory cells 20A and 20B are in the OFF state. Further, the write bit lines WBL and WBLN and the control lines PL and PLN that are coupled to the memory cells 20A and 20B each have a voltage of "0 V". Further, in this example, the power supply node PWR of each of the memory cells 20A and 20B has a voltage of "1 V".

In this example, in the memory cell 20A, the polarization state of the ferroelectric capacitor 31 is the polarization state S2, and the polarization state of the ferroelectric capacitor 32 is the polarization state S1. Accordingly, the voltage of the node N1 is "0 V", and the voltage of the node N2 is "1 V". In contrast, in the memory cell 20B, the polarization state of the ferroelectric capacitor 31 is the polarization state S1, and the polarization state of the ferroelectric capacitor 32 is the polarization state S2. Accordingly, the voltage of the node N1 is "1 V", and the voltage of the node N2 is "0 V".

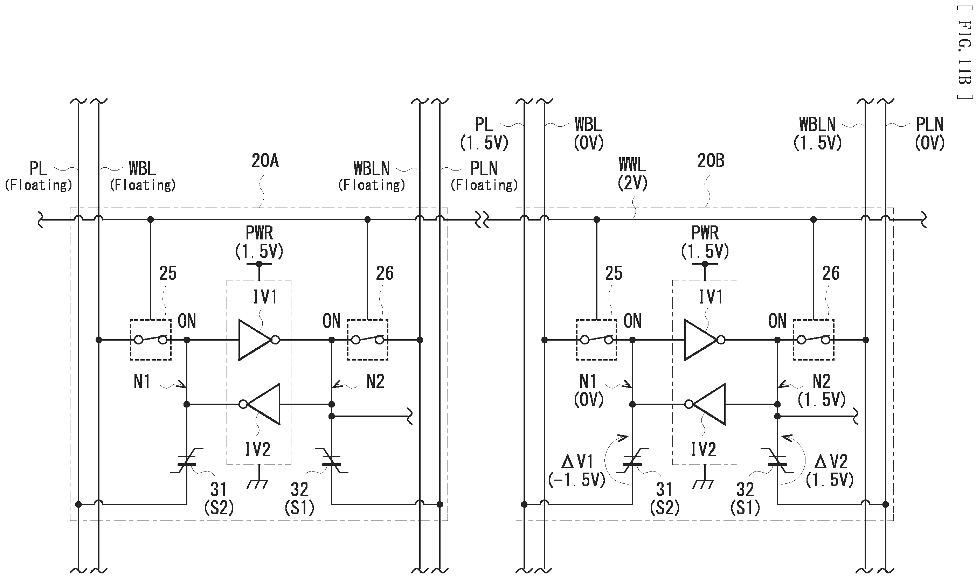

Next, the semiconductor circuit 1 performs the operation OP11 for the memory cell 20B. In the operation OP11, as illustrated in FIG. 11B, the drive section 13 applies "2 V" to the write word line WWL coupled to the memory cells 20A and 20B. This brings the transistors 25 and 26 in the memory cells 20A and 20B into the ON state. Then, the drive section 14 applies "0 V" to the write bit line WBL and the control line PLN that are coupled to the memory cell 20B, and applies "1.5 V" to the write bit line WBLN and the control line PL that are coupled to the memory cell 20B. As a result, in the memory cell 20B, the polarization state of the ferroelectric capacitor 31 becomes the polarization state S2 (the negative state) because the voltage ΔV1 of the ferroelectric capacitor 31 is "-1.5 V", and the polarization state of the ferroelectric capacitor 32 becomes the polarization state S1 (the positive state) because the voltage ΔV2 of the ferroelectric capacitor 32 is "-1.5 V". In such a manner, in the memory cell 20B, the operation OP11 causes the polarization state of the ferroelectric capacitor 31 to change from the polarization state S1 (FIG. 11A) to the polarization state S2 (FIG. 11B), and causes the polarization state of the ferroelectric capacitor 32 to change from the polarization state S2 (FIG. 11A) to the polarization state S1 (FIG. 11B).

In contrast, in this example, no data is to be written into the memory cell 20A, and therefore the drive section 14 brings the write bit lines WBL and WBLN and the control lines PL and PLN that are coupled to the memory cell 20A into a floating state. At this time, it could happen that the retention circuit including the inverters IV1 and IV2 is unable to maintain the voltages of the nodes N1 and N2. In particular, in a case where the transistors 21 to 24 of the inverters IV1 and IV2 are small in size or where what is called a β-ratio is small, it is difficult to maintain the voltages of the node N1 and N2. Even in such a case, in the memory cell 20A, the polarization state of the ferroelectric capacitor 31 is maintained as the polarization state S2, and the polarization state of the ferroelectric capacitor 32 is maintained as the polarization state S1.

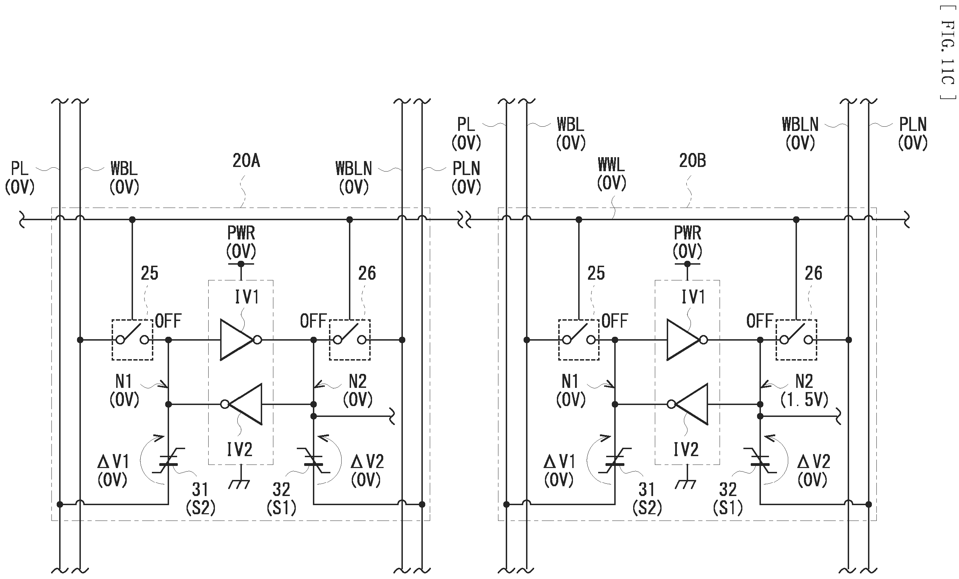

Next, the semiconductor circuit 1 performs the operation OP12. In the operation OP12, as illustrated in FIG. 11C, the drive section 13 applies "0 V" to the write word line WWL coupled to the memory cells 20A and 20B. This brings the transistors 25 and 26 in the memory cells 20A and 20B into the OFF state. Then, the drive section 14 applies "0 V" to the write bit lines WBL and WBLN and the control lines PL and PLN that are coupled to the memory cells 20A and 20B. Then, the controller 11 applies "0 V" to the power supply node PWR. Accordingly, in the memory cells 20A and 20B, the voltage ΔV1 of the ferroelectric capacitor 31 is "0 V", and the voltage ΔV2 of the ferroelectric capacitor 32 is "0 V". Thus, the polarization states of the ferroelectric capacitors 31 and 32 are maintained at the memory cells 20A and 20B.

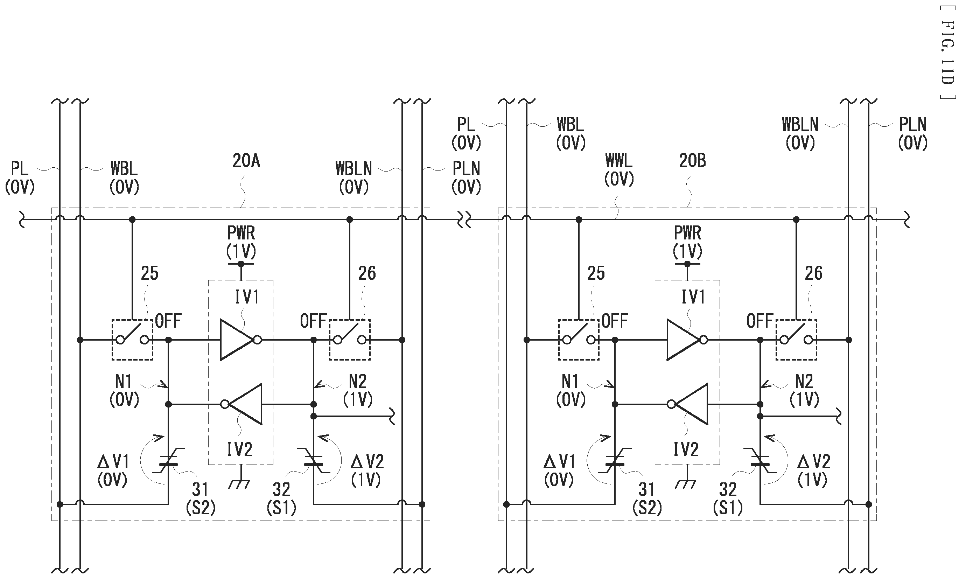

Next, the semiconductor circuit 1 performs the operation OP13. In the operation OP13, as illustrated in FIG. 11D, the drive section 13 applies "0 V" to the write word line WWL. This brings the transistors 25 and 26 in the memory cells 20A and 20B into the OFF state. Then, the drive section 14 applies "0 V" to the write bit lines WBL and WBLN and the control lines PL and PLN that are coupled to the memory cells 20A and 20B. Then, the controller 11 applies "1 V" to the power supply node PWR. Accordingly, operations illustrated in FIGs. 8A, 8B, 9A, 9B, 10A, and 10B are performed in each of the memory cells 20A and 20B. As a result, in the memory cell 20A, the voltage of the node N1 becomes "0 V" and the voltage of the node N2 becomes "1 V" in accordance with the polarization states of the ferroelectric capacitors 31 and 32 of the memory cell 20A. Further, in the memory cell 20B, the voltage of the node N1 becomes "0 V" and the voltage of the node N2 becomes "1 V" in accordance with the polarization states of the ferroelectric capacitors 31 and 32 of the memory cell 20B.

In this way, in the semiconductor circuit 1, it could happen that in the memory cell 20A on which no data writing is to be performed, the voltages of the nodes N1 and N2 are not maintainable in a case where the transistors 25 and 26 are brought into the ON state, as illustrated in FIG. 11B. Even in such a case, as illustrated in FIG. 11D, it is possible to restore the original voltages of the nodes N1 and N2 on the basis of data stored in the ferroelectric capacitors 31 and 32 of the memory cell 20A. As a result, it is possible for the semiconductor circuit 1 to prevent the easy occurrence of the write disturb.

### (Read Operation OP2 and Standby Operation OP3)

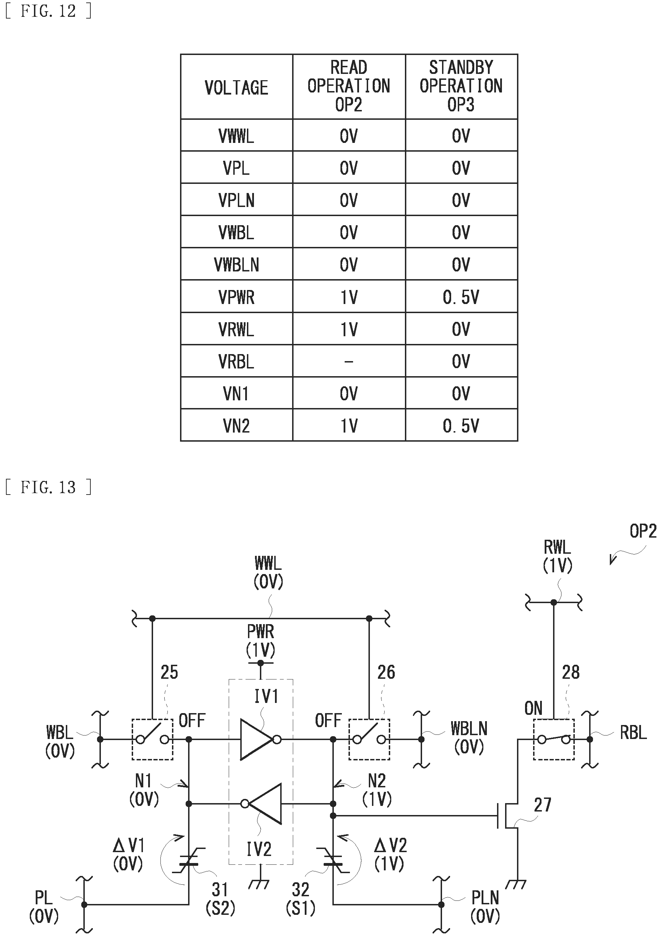

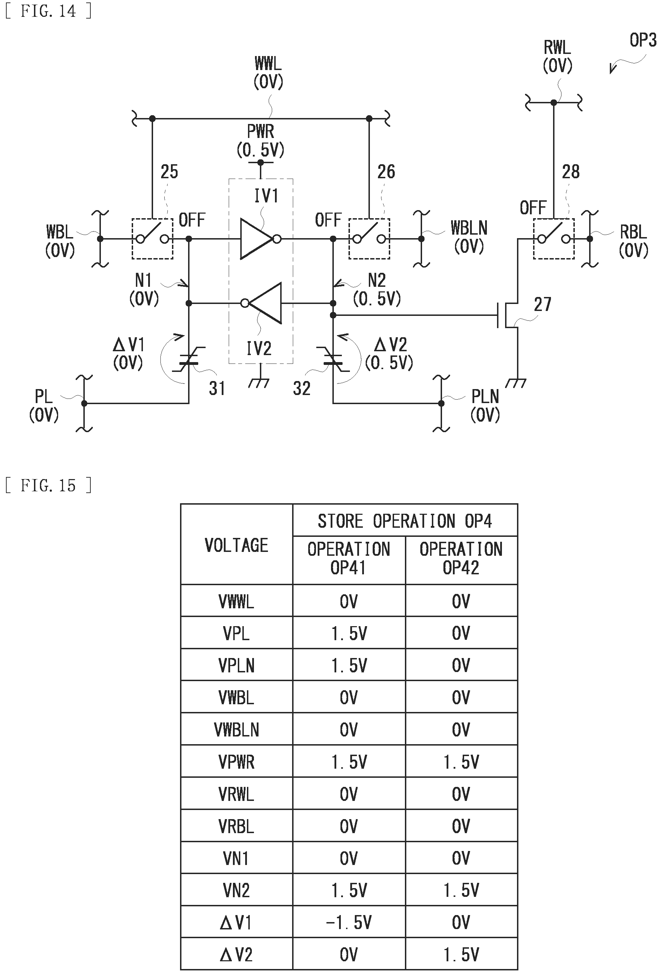

FIG. 12 illustrates an example of the read operation OP2 and the standby operation OP3 on the memory cell 20 for data. The read operation OP2 is an operation to read data from the memory cell 20. The standby operation OP3 is an operation to retain data while reducing power consumption by lowering the power supply voltage to be supplied to the memory cell 20. FIG. 13 illustrates an example of the read operation OP2. FIG. 14 illustrates an example of the standby operation OP3.

First, the read operation OP2 will be described in detail with reference to FIGs. 12 and 13.

In advance of the read operation OP2, the sense amplifier section 15 performs a precharge operation on the read bit line RBL in this example. This causes the read bit line RBL to be precharged to "1 V", for example.

As illustrated in FIGs. 12 and 13, in the read operation OP2, the drive section 13 sets the voltage VWWL of the write word line WWL to "0 V" and sets the voltage VRWL of the read word line RWL to "1 V". This brings the transistors 25 and 26 into the OFF state and brings the transistor 28 into the ON state. The drive section 14 sets the voltage VWBL of the write bit line WBL, the voltage VWBLN of the write bit line WBLN, the voltage VPL of the control line PL, and the voltage VPLN of the control line PLN to "0 V".

In this example, the voltage VN1 of the node N1 is "0 V" and the voltage VN2 of the node N2 is "1 V". Accordingly, the transistor 27 is in the ON state and therefore a current flows from the read bit line RBL having been precharged toward the ground node through the transistor 28 and the transistor 27. As a result, the voltage VRBL of the read bit line RBL drops from the precharged voltage (for example, "1 V"). Conversely, in a case where the voltage VN1 of the node N1 is "1 V" and the voltage VN2 of the node N2 is "0 V", the transistor 27 is in the OFF state and therefore the voltage VRBL of the read bit line RBL is maintained at the precharged voltage (for example, "1 V"). The sense amplifier section 15 compares such a voltage VRBL of the read bit line RBL and a predetermined threshold voltage. In such a manner, the semiconductor circuit 1 reads data stored in the memory cell 20.

It is to be noted that in this example, the sense amplifier section 15 precharges the voltage of the read bit line RBL to, for example, "1 V"; however, this is non-limiting. For example, the voltage of the read bit line RBL may be predischarged to "0 V", for example. In this case, the drain of the transistor 27 is coupled to the power supply node PWR, and the source of the transistor 27 is coupled to the drain of the transistor 28. The drain of the transistor 28 is coupled to the source of the transistor 27, and the source of the transistor 28 is coupled to the rad bit line RBL. In a case where the voltage VN1 of the node N1 is "0 V" and the voltage VN2 of the node N2 is "1 V", the transistor 27 is in the ON state and therefore a current flows from the power supply node PWR through the transistor 27 and the transistor 28 toward the read bit line RBL having been predischarged. As a result, the voltage VRBL of the read bit line RBL rises from the predischarged voltage (for example, "0 V"). Conversely, in the case where the voltage VN1 of the node N1 is "1 V" and the voltage VN2 of the node N2 is "0 V", the transistor 27 is in the OFF state and therefore the voltage VRBL of the read bit line RBL is maintained at the predischarged voltage (for example, "0 V"). The sense amplifier section 15 compares such a voltage VRBL of the read bit line RBL and the predetermined threshold voltage. In such a manner, it is possible for the semiconductor circuit 1 to read data stored in the memory cell 20.

In this way, the semiconductor circuit 1 performs the read operation OP2 through the use of the transistors 27 and 28. This makes it possible to read data in the memory cell 20 while allowing the transistors 25 and 26 to remain in the OFF state. As a result, it is possible for the semiconductor circuit 1 to prevent an easy occurrence of a read disturb.

That is, for example, a semiconductor circuit may sometimes be configured without the transistors 27 and 28 so as to read data through the transistors 25 and 26. In such a case, it could happen that bringing the transistors 25 and 26 into the ON state in the read operation causes the retention circuit including the inverters IV1 and IV2 to be unable to maintain the voltages of the nodes N1 and N2. In particular, in the case where the transistors 21 to 24 of the inverters IV1 and IV2 are small in size or where what is called the β-ratio is small, it is difficult for the inverters IV1 and IV2 to maintain the voltages of the node N1 and N2. In such a case, it becomes difficult to read data stored in the memory cell 20. As a result, the read disturb can occur in the semiconductor circuit 1.

In contrast, in the semiconductor circuit 1, the transistors 27 and 28 are provided and data is read through the transistor 28, which allows the transistors 25 and 26 to remain in the OFF state. This makes it easier for the retention circuit including the inverters IV1 and IV2 to maintain the voltages of the nodes N1 and N2. As a result, it is possible for the semiconductor circuit 1 to prevent the easy occurrence of the read disturb.

Next, the standby operation OP3 will be described in detail with reference to FIGs. 12 and 14.

As illustrated in FIGs. 12 and 14, in the standby operation OP3, the drive section 13 sets the voltage VWWL of the write word line WWL to "0 V" and sets the voltage VRWL of the read word line RWL to "0 V". This brings the transistors 25, 26, and 28 into the OFF state. The drive section 14 sets the voltage VWBL of the write bit line WBL, the voltage VWBLN of the write bit line WBLN, the voltage VPL of the control line PL, and the voltage VPLN of the control line PLN to "0 V". Then, the controller 11 sets the voltage VPWR of the power supply node PWR to "0.5 V". In this example, the voltage VN1 of the node N1 is "0 V", and the voltage VN2 of the node N2 is "0.5 V". The retention circuit including the inverters IV1 and IV2 maintains the voltages of the nodes N1 and N2.

In this way, the semiconductor circuit 1 retains data in the memory cell 20 with the voltage VPWR of the power supply node PWR set to a low voltage. This makes it possible for the semiconductor circuit 1 to reduce power consumption in a case where the write operation OP1 or the read operation OP2 is not performed.

### (Store Operation OP4)

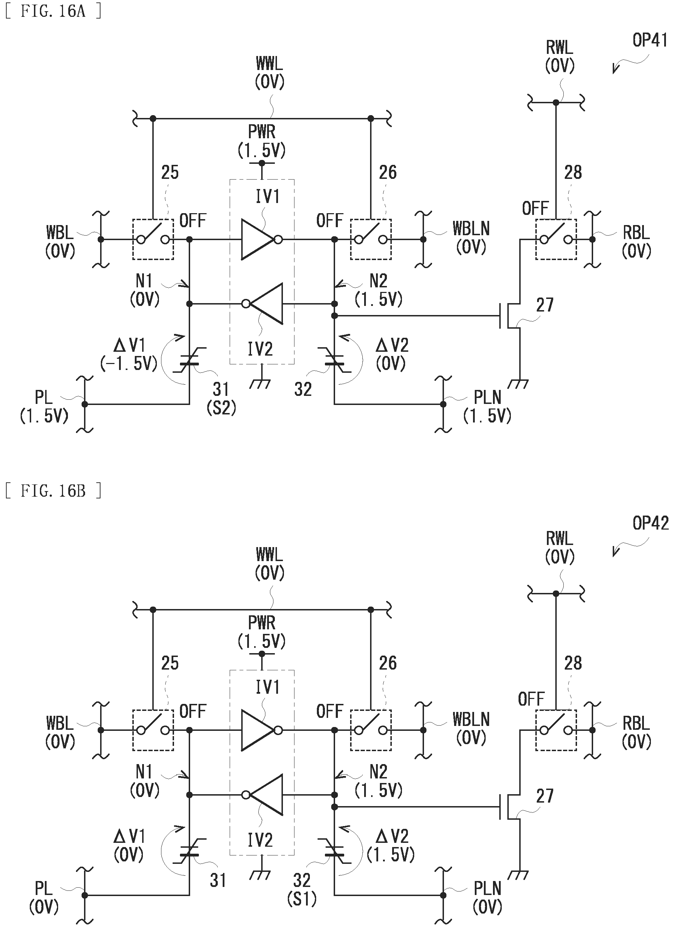

FIG. 15 illustrates an example of the store operation OP4 on the memory cell 20 for data. The store operation OP4 is an operation to transfer data stored in the retention circuit including the inverters IV1 and IV2 to the ferroelectric capacitors 31 and 32. The store operation OP4 includes two operations OP41 and OP42. FIG. 16A illustrates an example of the operation OP41. FIG. 16B illustrates an example of the operation OP42.

First, the semiconductor circuit 1 performs the operation OP41 to thereby cause one of the two ferroelectric capacitors 31 and 32 to store data (FIG. 16A). Specifically, first, the drive section 13 sets the voltage VWWL of the write word line WWL and the voltage VWRL of the read word line RWL to "0 V". This brings the transistors 25, 26, and 28 into the OFF state. Then, the drive section 14 sets the voltage VWBL of the write bit line WBL and the voltage VWBLN of the write bit line WBLN to "0 V". Further, the drive section 14 sets the voltage VPL of the control line PL and the voltage VPLN of the control line PLN to "1.5 V". Then, the controller 11 sets the voltage VPWR of the power supply node PWR to "1.5 V".

In this example, the voltage VN1 of the node N1 is "0 V", and the voltage VN2 of the node N2 is "1.5 V". Accordingly, the voltage ΔV1 of the ferroelectric capacitor 31 is "-1.5 V", and the voltage ΔV2 of the ferroelectric capacitor 32 is "0 V". As a result, the polarization state of the ferroelectric capacitor 31 becomes the polarization state S2 (the negative state). In contrast, the polarization state of the ferroelectric capacitor 32 is allowed to remain being the previous state. In this way, in the operation OP41, data is stored in the ferroelectric capacitor coupled to one of the two nodes N1 and N2 that is "0 V" in voltage.

Next, the semiconductor circuit 1 performs the operation OP42 to thereby cause another one of the two ferroelectric capacitors 31 and 32 to store data (FIG. 16B). Specifically, the drive section 14 sets the voltage VPL of the control line PL and the voltage VPLN of the control line PLN to "0V".

In this example, the voltage VN1 of the node N1 is "0 V", and the voltage VN2 of the node N2 is "1.5 V". Accordingly, the voltage ΔV1 of the ferroelectric capacitor 31 is "0 V", and the voltage ΔV2 of the ferroelectric capacitor 32 is "1.5 V". As a result, the polarization state of the ferroelectric capacitor 32 becomes the polarization state S1 (the positive state). In contrast, the polarization state of the ferroelectric capacitor 31 is allowed to remain being the previous state. In this way, in the operation OP42, data is stored in the ferroelectric capacitor coupled to one of the two nodes N1 and N2 that is "1.5 V" in voltage.

It is to be noted that in this example, the semiconductor circuit 1 performs the operations in the order of the operation OP41 and the operation OP42; however, this is non-limiting, and the semiconductor circuit 1 may thus perform the operations in the order of the operation OP42 and the operation OP41.

In such a manner, the polarization state of the ferroelectric capacitor 31 is set to a polarization state corresponding to the voltage VN1 of the node N1, and the polarization state of the ferroelectric capacitor 32 is set to a polarization state corresponding to the voltage VN2 of the node N2. As a result, the data stored in the retention circuit including the inverters IV1 and IV2 is transferred to the ferroelectric capacitors 31 and 32.

Thereafter, for example, the semiconductor circuit 1 may perform what is called power gating to allow the controller 11 to set the voltage VPWR of the power supply node PWR to "0 V". At this time, no electric power is consumed in the memory cell 20. In addition, thereafter, for example, when the controller 11 sets the voltage VPWR of the power supply node PWR to "1 V", the data stored in the ferroelectric capacitors 31 and 32 is transferred to the retention circuit including the inverters IV1 and IV2, as with the case of the operation OP13 (FIGs. 8A, 8B, 9A, 9B, 10A, and 10C). In the semiconductor circuit 1, it is possible to reduce power consumption by performing such power gating.

As has been described, the semiconductor circuit 1 includes: the first inverter (the inverter IV1) configured to generate an inverted voltage of a voltage at the first node (the node N1) and configured to apply the inverted voltage to the second node (the node N2); the second inverter (the inverter IV2) configured to generate an inverted voltage of a voltage at the second node (the node N2) and configured to apply the inverted voltage to the first node (the node N1); the first bit line (the write bit line WBL) and the second bit line (the write bit line WBLN); the first transistor (the transistor 25) provided on a path coupling the first bit line and the first node to each other; the second transistor (the transistor 26) provided on a path coupling the second bit line and the second node to each other; the first control line (the control line PL) and the second control line (the control line PLN); the first ferroelectric capacitor (the ferroelectric capacitor 31) provided on a path coupling the first control line and the first node to each other; the second ferroelectric capacitor (the ferroelectric capacitor 32) provided on a path coupling the second control line and the second node to each other; the third transistor (the transistor 27) including the gate, the source, and the drain, the gate being coupled to the second node; the first signal line (the read bit line RBL); and the fourth transistor (the transistor 28) provided on a path coupling the first signal line (the read bit line RBL) and one of the source and the drain of the third transistor (the third transistor 27) to each other. With such a configuration, in the semiconductor circuit 1, as illustrated in FIGs. 11A to 11D, for example, it is possible to temporarily store data in the ferroelectric capacitors 31 and 32 in the write operation OP1. This make it possible to prevent the easy occurrence of the write disturb. Further, in the semiconductor circuit 1, as illustrated in FIG. 13, for example, it is possible to perform the read operation OP2 through the use of the transistors 27 and 28. This makes it possible to prevent the easy occurrence of the read disturb. As a result, in the semiconductor circuit 1, it is possible to store data stably. Further, because the semiconductor circuit 1 makes it possible to prevent the easy occurrence of the write disturb and the read disturb as described above and to prevent a reading speed from depending on the transistors 21 to 24 of the inverters IV1 and IV2, it is possible to reduce the size of the transistors 21 to 24 of the inverters IV1 and IV2 and reduce the β-ratio. In this case, it is possible to reduce the size of the semiconductor circuit 1.

In addition, the semiconductor circuit 1 further includes the drive section (the drive section 13 and 14) configured to: apply voltages to the first bit line (the write bit line WBL), the second bit line (the write bit line WBLN), the first control line (the control line PL), and the second control line (the control line PLN); control the operations of the first transistor (the transistor 25) and the second transistor (the transistor 26); and perform a first drive operation (the operation OP11), a second drive operation (the operation OP12), and a third drive operation (the operation OP13) in this order. The first drive operation (the operation OP11) includes: bringing the first transistor (the transistor 25) and the second transistor (the transistor 26) into the ON state; applying one of an active voltage (for example, "1.5 V") and a ground voltage to the first bit line (the write bit line WBL) and the second control line (the control line PLN); and applying another of the active voltage (for example, "1.5 V") and the ground voltage to the second bit line (the write bit line WBLN) and the first control line (the control line PL). The second drive operation (the operation OP12) includes: bringing the first transistor (the transistor 25) and the second transistor (the transistor 26) into the OFF state; and stopping power supply to the first inverter (the inverter IV1) and the second inverter (the inverter IV2). The third drive operation (the operation OP13) includes: bringing the first transistor (the transistor 25) and the second transistor (the transistor 26) into the OFF state; applying the ground voltage to the first control line (the control line PL) and the second control line (the control line PLN); and performing the power supply to the first inverter (the inverter IV1) and the second inverter (the inverter IV2). This makes it possible, as illustrated in FIGs. 5 to 7, for the semiconductor circuit 1 to cause data to be stored in the ferroelectric capacitors 31 and 32, to temporarily stop electric power supply to the inverters IV1 and IV2, and to resume the electric power supply to the inverters IV1 and IV2 and transfer the data stored in the ferroelectric capacitors 31 and 32 to the retention circuit including the inverters IV1 and IV2. As a result, in the semiconductor circuit 1, it is possible to prevent the easy occurrence of the write disturb, and accordingly, it is possible to store data stably.

In addition, the semiconductor circuit 1 further includes the sense amplifier section 15 coupled to the first signal line (the read bit line RBL). The drive section (the drive sections 13 and 14) is further configured to control the operation of the fourth transistor (the transistor 28) and configured to perform a fourth drive section (the read operation OP2). The fourth drive operation (the read operation OP2) includes: bringing the first transistor (the transistor 25) and the second transistor (the transistor 26) into the OFF state; and bringing the fourth transistor (the transistor 28) into the ON state. The sense amplifier section 15 is configured to operate on the basis of a signal on the first signal line (the read bit line RBL) during a period when the drive section (the drive sections 13 and 14) is performing the fourth drive operation (the read operation OP2). This makes it possible, as illustrated in FIG. 13, for the semiconductor circuit 1 to read data through the transistor 28 while allowing the transistor 25 and 26 to remain in the OFF state. As a result, in the semiconductor circuit 1, it is possible to prevent the easy occurrence of the read disturb, and accordingly, it is possible to store data stably.

### [Effects]

As described above, in the present embodiment, there are provided a first inverter, a second inverter, a first bit line and a second bit line, a first transistor, a second transistor, a first control line and a second control line, a first ferroelectric capacitor, a second ferroelectric capacitor, a third transistor, a first signal line, and a fourth transistor. The first inverter is configured to generate an inverted voltage of a voltage at a first node and configured to apply the inverted voltage to a second node. The second inverter is configured to generate an inverted voltage of a voltage at the second node and configured to apply the inverted voltage to the first node. The first transistor is provided on a path coupling the first bit line and the first node to each other. The second transistor is provided on a path coupling the second bit line and the second node to each other. The first ferroelectric capacitor is provided on a path coupling the first control line and the first node to each other. The second ferroelectric capacitor is provided on a path coupling the second control line and the second node to each other. The third transistor includes a gate, a source, and a drain, the gate being coupled to the second node. The fourth transistor is provided on a path coupling the first signal line and one of the source and the drain of the third transistor to each other. This makes it possible to store data stably.

In the present embodiment, further provided is a drive section that is configured to: apply voltages to the first bit line, the second bit line, the first control line, and the second control line; control operations of the first transistor and the second transistor; and perform a first drive operation, a second drive operation, and a third drive operation in this order. The first drive operation includes: bringing the first transistor and the second transistor into an ON state; applying one of an active voltage and a ground voltage to the first bit line and the second control line; and applying another of the active voltage and the ground voltage to the second bit line and the first control line. The second drive operation includes: bringing the first transistor and the second transistor into an OFF state; and stopping power supply to the first inverter and the second inverter. The third drive operation includes: bringing the first transistor and the second transistor into the OFF state; applying the ground voltage to the first control line and the second control line; and performing the power supply to the first inverter and the second inverter. This makes it possible to store data stably.

In the present embodiment, further provided is a sense amplifier section coupled to the first signal line. The drive section is further configured to control an operation of the fourth transistor and configured to perform a fourth drive operation. The fourth drive operation includes: bringing the first transistor and the second transistor into the OFF state; and bringing the fourth transistor into the ON state. The sense amplifier section is configured to operate on the basis of a signal on the first signal line during a period when the drive section is performing the fourth drive operation. This makes it possible to store data stably.

### [Modification Example 1-1]

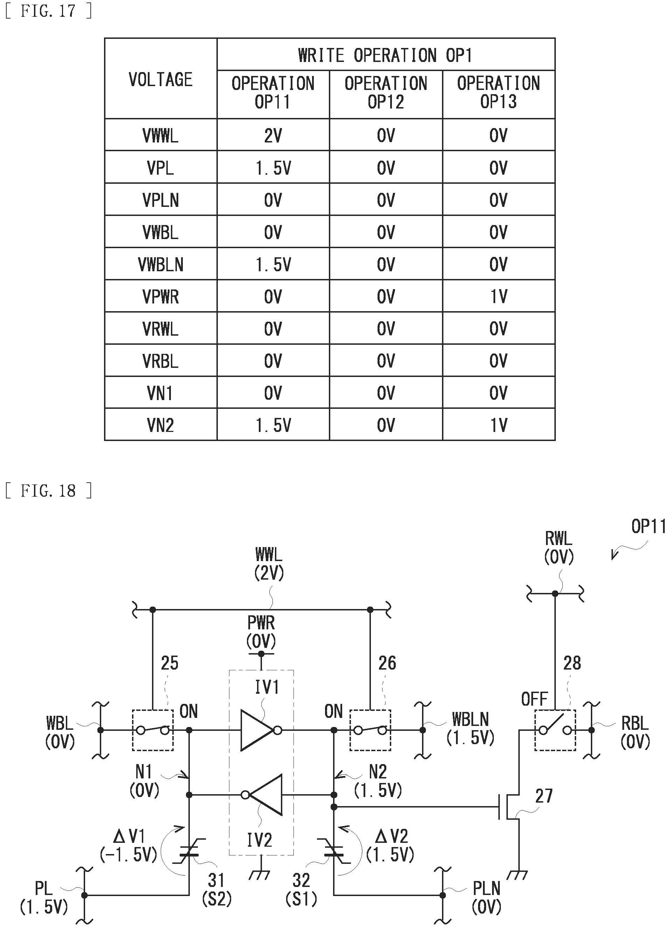

In the foregoing embodiment, as illustrated in FIGs. 4 and 5, power supply is performed on the retention circuit including the inverters IV1 and IV2 in the operation OP11 of the write operation OP1; however, this is non-limiting. Alternatively, for example, as illustrated in FIGs. 17 and 18, no power supply may be performed in the operation OP11. As illustrated in FIGs. 17 and 18, the controller 11 sets the voltage VPWR of the power supply node PWR to "0 V" in the operation OP11. Even in such a case, the voltage ΔV1 of the ferroelectric capacitor 31 becomes "-1.5 V", and the voltage ΔV2 of the ferroelectric capacitor 32 becomes "1.5 V". As a result, the polarization state of the ferroelectric capacitor 31 becomes the polarization state S2, and the polarization state of the ferroelectric capacitor 32 becomes the polarization state S1.

### [Modification Example 1-2]

In the foregoing embodiment, in the read operation OP2, the sense amplifier section 15 performs the precharge operation on the read bit line RBL and reads data stored in the memory cell 20, on the basis of the voltage of the read bit line RBL after the transistor 28 is brought into the ON state; however, this is non-limiting. Alternatively, for example, the sense amplifier section 15 may refrain from performing the precharge operation and may read data stored in the memory cell 20, on the basis of a current flowing through the read bit line RBL after the transistor 28 is brought into the ON state. For example, in the case where the voltage VN1 of the node N1 is "0 V" and the voltage VN2 of the node N2 is "1 V", the transistor 27 is in the ON state and therefore a current flows through the read bit line RBL. Further, for example, in the case where the voltage VN1 of the node N1 is "1 V" and the voltage VN2 of the node N2 is "0 V", the transistor 27 is in the OFF state and therefore no current flows through the read bit line RBL. On the basis of the current at the read bit line RBL as described above, it is possible for the sense amplifier section 15 to read data stored in the memory cell 20.

### [Other Modification Examples]

Further, two or more of these modification examples may be combined.

### <2. Second Embodiment>

Next, a description will be given of a semiconductor circuit 2 according to a second embodiment. It is to be noted that components that are substantially the same as those of the semiconductor circuit 1 according to the first embodiment described above are denoted by the same reference signs and descriptions thereof are omitted as appropriate.

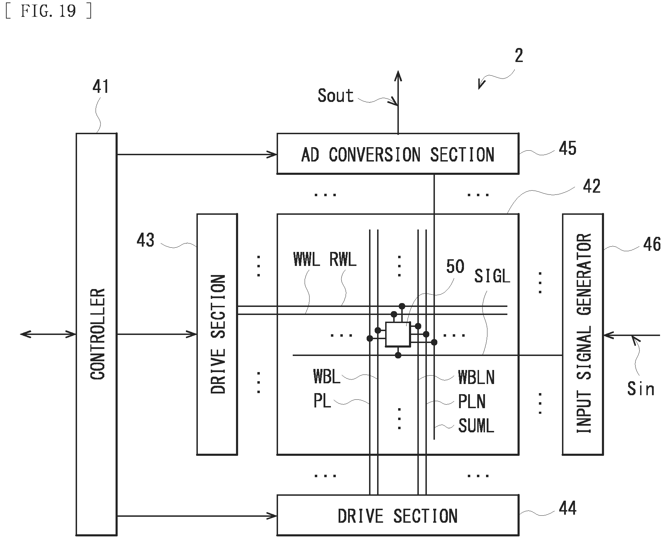

FIG. 19 illustrates a configuration example of the semiconductor circuit 2. The semiconductor circuit 2 is a computing memory, and is a multiply-accumulate circuit that performs a weighted addition on signals. The semiconductor circuit 2 includes a controller 41, a memory cell array 42, drive sections 43 and 44, an AD (Analog to Digital) conversion section 45, and an input signal generator 46.

The controller 41 is configured to control an operation of the semiconductor circuit 2 by controlling operations of the memory cell array 42, the drive sections 43 and 44, and the AD conversion section 45. Specifically, the controller 41 controls the operation of the semiconductor circuit 2 to cause data to be written into the memory cell array 42 on the basis of the write command and the write data supplied from the outside, and to perform a multiply-accumulate operation on the basis of a computation command supplied from the outside and output a result of the operation as a signal Sout. Further, the controller 41 controls a power supply voltage of each circuit in the semiconductor circuit 2 depending on the operation.

The memory cell array 42 includes a plurality of memory cells 50, the plurality of write word lines WWL, the plurality of read word lines RWL, the plurality of write bit lines WBL, the plurality of write bit lines WBLN, the plurality of control lines PL, the plurality of control lines PLN, a plurality of signal lines SIGL, and a plurality of signal lines SUML.

Each of the plurality of memory cells 50 is configured to store data. The plurality of memory cells 50 are disposed in a matrix. The memory cells 50 are coupled to the write word lines WWL, the read word lines RWL, the write bit lines WBL and WBLN, the control lines PL and PLN, the signal lines SIGL, and the signal lines SUML. The signal lines SIGL extend in the horizontal direction in FIG. 19, and one end of each of the signal lines SIGL is coupled to the input signal generator 46. The signal lines SUML extend in the vertical direction in FIG. 19, and one end of each of the signal lines SUML is coupled to the AD conversion section 45.

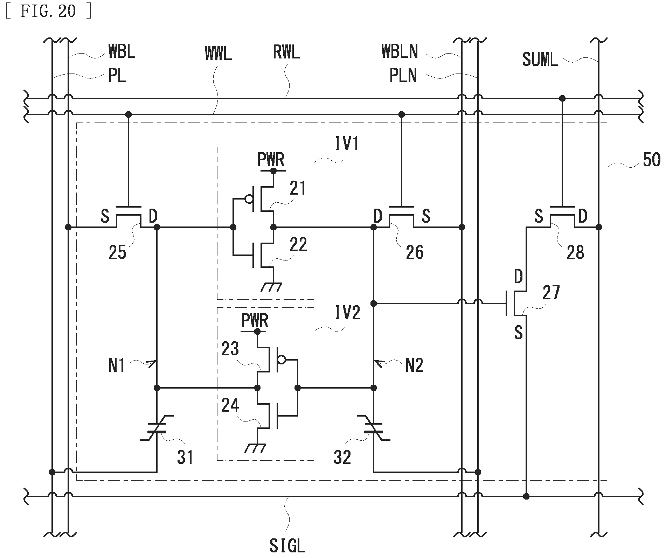

FIG. 20 illustrates a configuration example of the memory cell 50. The memory cell 50 includes the transistors 21 to 28 and the ferroelectric capacitors 31 and 32. The memory cell 50 has a circuit configuration similar to that of the memory cell 20 (FIG. 2) according to the foregoing first embodiment. The source of the transistor 27 is coupled to the signal line SIGL. The drain of the transistor 28 is coupled to the signal line SUML.

The drive section 43 (FIG. 19) is coupled to the plurality of write word lines WWL and the plurality of read word lines RWL of the memory cell array 42, and is configured to apply a signal to the write word lines WWL and the read word lines RWL of the memory cell array 42 on the basis of a control signal supplied from the controller 41.

The drive section 44 is coupled to the plurality of write bit lines WBL, the plurality of write bit lines WBLN, the plurality of control lines PL, and the plurality of control lines PLN of the memory cell array 42, and is configured to apply a signal to the write bit lines WBL and WBLN and the control lines PL and PLN of the memory cell array 42 on the basis of a control signal supplied from the controller 41.

The AD conversion section 45 is coupled to the plurality of signal lines SUML of the memory cell array 42, and is configured to, on the basis of a control signal supplied from the controller 41, convert an analog signal supplied from the memory cell array 42 through the signal line SUML into a digital code and output the digital code as a signal Sout.

The input signal generator 46 is configured to generate a plurality of signals on the basis of a signal Sin and the generated plurality of signals to the respective signal lines SIGL of the memory cell array 42. Each of the plurality of signals is a PWM (Pulse Width Modulation) signal, for example.

Here, the inverter IV1 corresponds to a specific example of the "first inverter" and a "third inverter" in one embodiment of the present disclosure. The inverter IV2 corresponds to a specific example of the "second inverter" and a "fourth inverter" in one embodiment of the present disclosure. The node N1 corresponds to a specific example of the "first node" and a "third node" in one embodiment of the present disclosure. The node N2 corresponds to a specific example of the "second node" and a "fourth node" in one embodiment of the present disclosure. The transistor 25 corresponds to a specific example of the "first transistor" and a "fifth transistor" in one embodiment of the present disclosure. The transistor 26 corresponds to a specific example of the "second transistor" and a "sixth transistor" in one embodiment of the present disclosure. The ferroelectric capacitor 31 corresponds to a specific example of the "first ferroelectric capacitor" and a "third ferroelectric capacitor" in one embodiment of the present disclosure. The ferroelectric capacitor 32 corresponds to a specific example of the "second ferroelectric capacitor" and a "fourth ferroelectric capacitor" in one embodiment of the present disclosure. The transistor 27 corresponds to a specific example of the "third transistor" and a "seventh transistor" in one embodiment of the present disclosure. The signal line SUML corresponds to a specific example of the "first signal line" in one embodiment of the present disclosure. The signal line SIGL corresponds to a specific example of a "second signal line" and a "third signal line" in one embodiment of the present disclosure. The transistor 28 corresponds to a specific example of the "fourth transistor" and an "eighth transistor" in one embodiment of the present disclosure. The drive sections 43 and 44 each correspond to a specific example of the "drive section" in one embodiment of the present disclosure. The AD conversion section 45 corresponds to a specific example of the "read section" in one embodiment of the present disclosure. The input signal generator 46 corresponds to a specific example of a "signal generator" in one embodiment of the present disclosure.

It is possible for the semiconductor circuit 2 to perform the write operation OP1, the standby operation OP3, and the store operation OP4 in a manner similar to that in a case of the semiconductor circuit 1 according to the foregoing first embodiment.

Further, by performing the read operation OP2, the semiconductor circuit 2 performs the multiply-accumulate operation on the plurality of signals generated by the input signal generator 46, through the use of data stored in the plurality of memory cells 50.

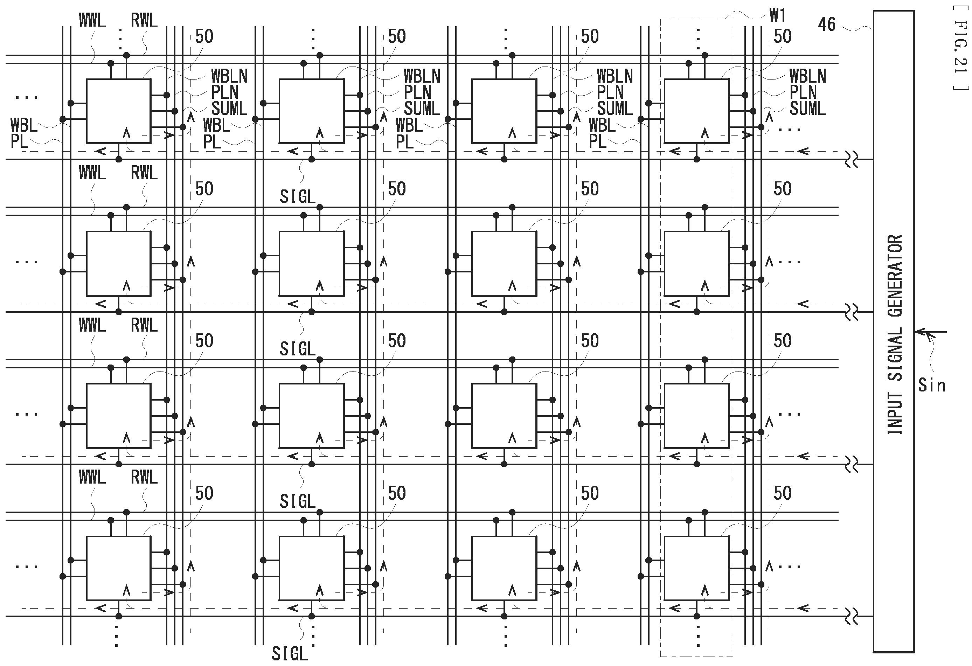

FIG. 21 illustrates an operation example of the multiply-accumulate operation to be performed by the semiconductor circuit 2. In FIG. 21, sixteen (= 4 × 4) memory cells 50 out of the plurality of memory cells 50 of the memory cell array 42 are illustrated. In this example, data is already stored in the plurality of memory cells 50 by the write operation OP1. By performing the read operation OP2 (FIGs. 12 and 13), the semiconductor circuit 2 performs the multiply-accumulate operation on the plurality of signals generated by the input signal generator 46, through the use of the data stored in the plurality of memory cells 50.

For example, the input signal generator 46 generates the plurality of signals and applies the generated signals to the plurality of signal lines SIGL. Multiple ones of the memory cells 50 in one column (a part W1) in the memory cell array 42 perform the multiply-accumulate operation on the plurality of signals generated by the input signal generator 46, through the use of the data stored in the memory cells 50.

For example, among the multiple ones of the memory cells 50 in one column, some memory cells 50 in which the voltage of the node N2 is at a high level (for example, 1 V) each allow a current corresponding to the signal line SIGL to flow through the signal line SUML, because the transistor 27 is in the ON state. Further, among the multiple ones of the memory cells 50 in one column, some memory cells 50 in which the voltage of the node N2 is at a low level (for example, 0 V) each allow no current to flow through the signal line SUML, because the transistor 27 is in the OFF state. In this way, the memory cell 50 performs a multiplication on the signal on the signal line SIGL with the data stored in the memory cell 50, and allows a current as a resultant of the multiplication to flow through the signal line SUML. Each of the multiple ones of the memory cells 50 in one column performs such an operation, which allows a total current of the currents as resultants of the multiplications to flow through the signal line SUML. In such a manner, a current as a resultant of the multiply-accumulate operation flows through the signal line SUML.

Ther AD conversion section 45 generates a digital code by performing AD conversion on the basis of the current as a resultant of the multiply-accumulate operation flowing through the signal line SUML.

In such a manner, the multiple ones of the memory cells 50 in one column each perform the multiply-accumulate operation on the plurality of signals generated by the input signal generator 46 and thereby allow a current to flow through the signal line SUML, and the AD conversion section 45 performs the AD conversion on the basis of the current as a resultant of the multiply-accumulate operation flowing through the signal line SUML. This similarly applies to each of the other plurality of columns. Then, the AD conversion section 45 outputs the digital code generated by the AD conversion as the signal Sout.

As has been described, the semiconductor circuit 2 includes: the first inverter (the inverter IV1) configured to generate an inverted voltage of a voltage at the first node (the node N1) and configured to apply the inverted voltage to the second node (the node N2); the second inverter (the inverter IV2) configured to generate an inverted voltage of a voltage at the second node (the node N2) and configured to apply the inverted voltage to the first node (the node N1); the first bit line (the write bit line WBL) and the second bit line (the write bit line WBLN); the first transistor (the transistor 25) provided on a path coupling the first bit line and the first node to each other; the second transistor (the transistor 26) provided on a path coupling the second bit line and the second node to each other; the first control line (the control line PL) and the second control line (the control line PLN); the first ferroelectric capacitor (the ferroelectric capacitor 31) provided on a path coupling the first control line and the first node to each other; the second ferroelectric capacitor (the ferroelectric capacitor 32) provided on a path coupling the second control line and the second node to each other; the third transistor (the transistor 27) including the gate, the source, and the drain, the gate being coupled to the second node; the first signal line (the signal line SUML); and the fourth transistor (the transistor 28) provided on a path coupling the first signal line (the signal line SUML) and one of the source and the drain of the third transistor (the third transistor 27) to each other. In this case also, in the semiconductor circuit 2, as in the case of the semiconductor circuit 1 according to the foregoing first embodiment, it is possible to temporarily store data in the ferroelectric capacitors 31 and 32 in the write operation OP1. This make it possible to prevent the easy occurrence of the write disturb. As a result, in the semiconductor circuit 2, it is possible to store data stably. Further, because the semiconductor circuit 2 makes it possible to prevent the easy occurrence of the write disturb in this way, it is possible to reduce the size of the transistors 21 to 24 of the inverters IV1 and IV2. In this case, it is possible to reduce the size of the semiconductor circuit 2.

### [Effects]

As described above, in the present embodiment, there are provided a first inverter, a second inverter, a first bit line and a second bit line, a first transistor, a second transistor, a first control line and a second control line, a first ferroelectric capacitor, a second ferroelectric capacitor, a third transistor, a first signal line, and a fourth transistor. The first inverter is configured to generate an inverted voltage of a voltage at a first node and configured to apply the inverted voltage to a second node. The second inverter is configured to generate an inverted voltage of a voltage at the second node and configured to apply the inverted voltage to the first node. The first transistor is provided on a path coupling the first bit line and the first node to each other. The second transistor is provided on a path coupling the second bit line and the second node to each other. The first ferroelectric capacitor is provided on a path coupling the first control line and the first node to each other. The second ferroelectric capacitor is provided on a path coupling the second control line and the second node to each other. The third transistor includes a gate, a source, and a drain, the gate being coupled to the second node. The fourth transistor is provided on a path coupling the first signal line and one of the source and the drain of the third transistor to each other. This makes it possible to store data stably.

### [Modification Example 2-1]

In the foregoing embodiment, the multiply-accumulate operation is performed on the plurality of signals generated by the input signal generator 46, through the use of one-bit data in the memory cell 50; however, this is non-limiting. Alternatively, for example, the multiply-accumulate operation may be performed on a single signal through the use of multiple-bit data. A semiconductor circuit 2A according to the present modification example will be described in detail below.

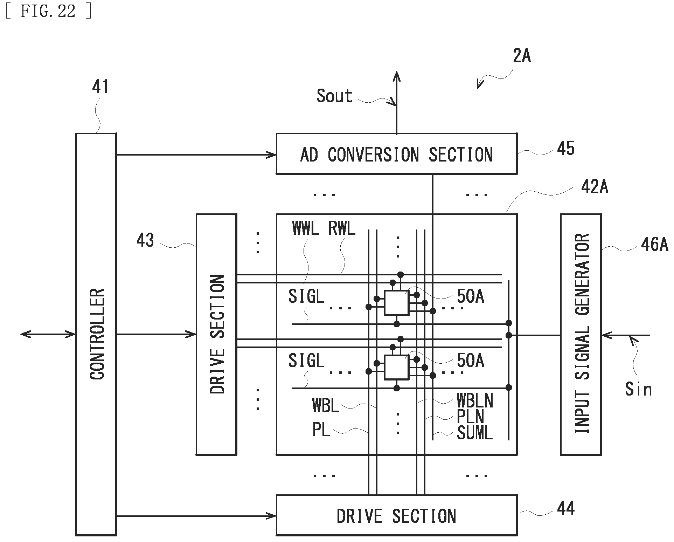

FIG. 22 illustrates a configuration example of the semiconductor circuit 2A. The semiconductor circuit 2A includes the controller 41, a memory cell array 42A, the drive sections 43 and 44, the AD conversion section 45, and an input signal generator 46A.

The memory cell array 42A includes a plurality of memory cells 50A, the plurality of write word lines WWL, the plurality of read word lines RWL, the plurality of write bit lines WBL, the plurality of write bit lines WBLN, the plurality of control lines PL, the plurality of control lines PLN, the plurality of signal lines SIGL, and the plurality of signal lines SUML. The signal lines SIGL are coupled to each other.

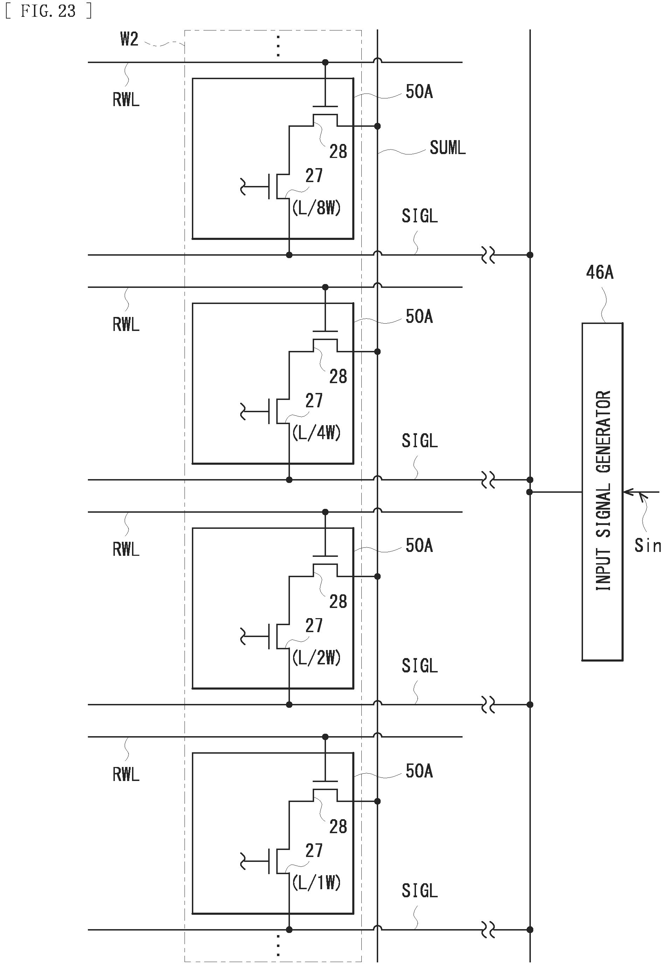

FIG. 23 illustrates a configuration example of a main part of the multiple ones of the memory cells 50A in one column. In FIG. 23, illustrations of the write word lines WWL, the write bit lines WBL and WBLN, and the control lines PL and PLN are omitted. In this example, gate widths of the transistors 27 in the multiple ones of the memory cells 50A in one column (a part W2) are set to mutually different widths such as 1W, 2W, 4W, 8W, and so on. This makes it possible for the memory cell 50A having the transistor 27 with a gate width of, for example, 2 W, to allow a twice larger current to flow through the signal line SUML, as compared with the memory cell 50A having the transistor 27 with a gate width of W.

The input signal generator 46A is configured to generate a signal on the basis of the signal Sin and to apply the generated signal to the plurality of signal lines SIGL of the memory cell array 42. The signal is a PWM signal, for example.

The multiple ones of the memory cells 50 in one column (the part W2) in the memory cell array 42A perform the multiply-accumulate operation on a single signal generated by the input signal generator 46, through the use of multiple-bit data stored in the plurality of memory cells 50. For example, data stored in the memory cell 50 having a gate width of 1W among the multiple ones of the memory cells 50 in one column (the part W2) is of the LSB (Least Significant Bit), data stored in the memory cell 50 having a gate width of 2W is of the second least significant bit, and data stored in the memory cell 50 having a gate width of 8W is of the third least significant bit. The multiple ones of the memory cells 50 in one column perform the multiply-accumulate operation through the use of such multiple-bit data. This allows a current as a resultant of the multiply-accumulate operation to flow through the signal line SUML. The AD conversion section 45 generates a digital code by performing AD conversion on the basis of the current as a resultant of the multiply-accumulate operation flowing through the signal line SUML.

In such a manner, the multiple ones of the memory cells 50 in one column each perform the multiply-accumulate operation on the signal generated by the input signal generator 46A and thereby allow a current to flow through the signal line SUML, and the AD conversion section 45 performs the AD conversion on the basis of the current as a resultant of the multiply-accumulate operation flowing through the signal line SUML. This similarly applies to each of the other plurality of columns. Then, the AD conversion section 45 outputs the digital code generated by the AD conversion as the signal Sout.

### [Modification Example 2-2]

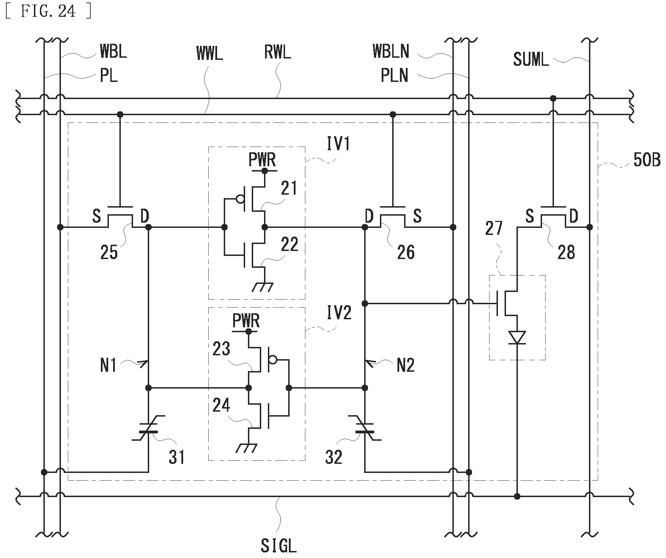

In the foregoing embodiment, the transistor 27 includes a typical FET (Field Effect Transistor); however, this is non-limiting. Alternatively, for example, as illustrated in FIG. 24, the transistor 27 may include a tunnel FET. This makes it possible to reduce a conductance of the transistor 27. Supposing a gate length of the transistor 27 is increased to thereby achieve a reduction in conductance, the transistor 27 would increase in size. By using the transistor 27 including the tunnel FET as described above, it is possible to reduce the conductance while suppressing an increase in size.

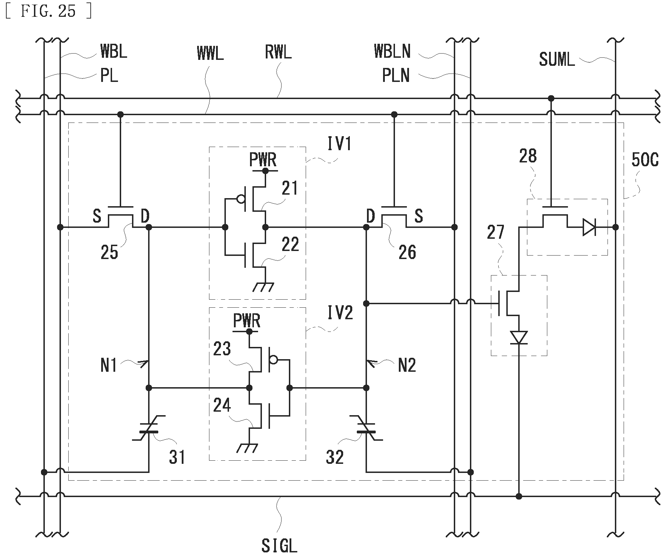

Further, for example, as illustrated in FIG. 25, the transistor 27 may include a tunnel FET and the transistor 28 may also include a tunnel FET.

### [Other Modification Example]

Further, two or more of these modification examples may be combined.

Although the present technology has been described above with reference to some embodiments and the modification examples, the present technology is not limited to these embodiments and the like, and may be modified in a variety of ways.

For example, manners of extension of the write word lines WWL, the read word lines RWL, the write bit lines WBL and WBLN, the read bit lines RBL, the control lines PL, the control lines PLN, the signal lines SIGL, and the signal lines SUML in each of the foregoing embodiments are not limited to the examples in the foregoing embodiments, and may be changed as appropriate.

For example, the memory cells 20 and 50 in the respective foregoing embodiments each include the transistors 21 to 28 and the ferroelectric capacitors 31 and 32; however, this is non-limiting. The memory cells 20 and 50 may each further include another element.

It is to be noted that the effects described herein are merely illustrative and non-limiting, and other effects may be included.

It is to be noted that the present technology may have the following configurations. The present technology having the following configurations makes it possible to store data stably.
(1) A semiconductor circuit including:
   a first inverter configured to generate an inverted voltage of a voltage at a first node and configured to apply the inverted voltage to a second node;
   a second inverter configured to generate an inverted voltage of a voltage at the second node and configured to apply the inverted voltage to the first node;
   a first bit line and a second bit line;
   a first transistor provided on a path coupling the first bit line and the first node to each other;
   a second transistor provided on a path coupling the second bit line and the second node to each other;
   a first control line and a second control line;
   a first ferroelectric capacitor provided on a path coupling the first control line and the first node to each other;
   a second ferroelectric capacitor provided on a path coupling the second control line and the second node to each other;
   a third transistor including a gate, a source, and a drain, the gate being coupled to the second node;
   a first signal line; and
   a fourth transistor provided on a path coupling the first signal line and one of the source and the drain of the third transistor to each other.
(2) The semiconductor circuit according to (1), further including
   a drive section configured to: apply voltages to the first bit line, the second bit line, the first control line, and the second control line; control operations of the first transistor and the second transistor; and perform a first drive operation, a second drive operation, and a third drive operation in this order, in which
   the first drive operation includes: bringing the first transistor and the second transistor into an ON state; applying one of an active voltage and a ground voltage to the first bit line and the second control line; and applying another of the active voltage and the ground voltage to the second bit line and the first control line,
   the second drive operation includes: bringing the first transistor and the second transistor into an OFF state; applying the ground voltage to the first control line and the second control line; and stopping power supply to the first inverter and the second inverter, and
   the third drive operation includes: bringing the first transistor and the second transistor into the OFF state; applying the ground voltage to the first control line and the second control line; and performing the power supply to the first inverter and the second inverter.
(3) The semiconductor circuit according to (2), further including
   a read section coupled to the first signal line, in which
   the drive section is further configured to control an operation of the fourth transistor and configured to perform a fourth drive operation,
   the fourth drive operation includes: bringing the first transistor and the second transistor into the OFF state; and bringing the fourth transistor into the ON state, and
   the read section is configured to operate on a basis of a signal on the first signal line during a period when the drive section is performing the fourth drive operation.
(4) The semiconductor circuit according to any one of (1) to (3), in which another of the source and the drain of the third transistor is coupled to a power supply node.
(5) The semiconductor circuit according to any one of (1) to (3), further including:
   a second signal line coupled to another of the source and the drain of the third transistor; and
   a signal generator configured to supply a signal to the second signal line.
(6) The semiconductor circuit according to (5), further including:
   a third inverter configured to generate an inverted voltage of a voltage at a third node and configured to apply the inverted voltage to a fourth node;
   a fourth inverter configured to generate an inverted voltage of a voltage at the fourth node and configured to apply the inverted voltage to the third node;
   a fifth transistor provided on a path coupling the first bit line and the third node to each other;
   a sixth transistor provided on a path coupling the second bit line and the fourth node to each other;
   a third ferroelectric capacitor provided on a path coupling the first control line and the third node to each other;
   a fourth ferroelectric capacitor provided on a path coupling the second control line and the fourth node to each other;
   a seventh transistor including a gate, a source, and a drain, the gate being coupled to the fourth node;
   an eighth transistor provided on a path coupling the first signal line and one of the source and the drain of the seventh transistor to each other; and
   a third signal line coupled to another of the source and the drain of the seventh transistor, in which
   the signal generator is configured to supply signals to the second signal line and the third signal line.
(7) The semiconductor circuit according to (6), in which the second signal line and the third signal line are coupled to each other.
(8) The semiconductor circuit according to (6) or (7), in which a size of the third transistor and a size of the seventh transistor are different from each other.
(9) The semiconductor circuit according to (8), in which a gate width of the third transistor and a gate width of the seventh transistor are different from each other.
(10) The semiconductor circuit according to any one of (6) to (9), in which each of the third transistor and the seventh transistor includes a tunnel field-effect transistor.
(11) A drive method including
   performing a first drive operation on a semiconductor circuit, the semiconductor circuit including: a first inverter configured to generate an inverted voltage of a voltage at a first node and configured to apply the inverted voltage to a second node; a second inverter configured to generate an inverted voltage of a voltage at the second node and configured to apply the inverted voltage to the first node; a first bit line and a second bit line; a first transistor provided on a path coupling the first bit line and the first node to each other; a second transistor provided on a path coupling the second bit line and the second node to each other; a first control line and a second control line; a first ferroelectric capacitor provided on a path coupling the first control line and the first node to each other; a second ferroelectric capacitor provided on a path coupling the second control line and the second node to each other; a third transistor including a gate, a source, and a drain, the gate being coupled to the second node; a first signal line; and a fourth transistor provided on a path coupling the first signal line and one of the source and the drain of the third transistor to each other, the first drive operation including: bringing the first transistor and the second transistor into an ON state; applying one of an active voltage and a ground voltage to the first bit line and the second control line; and applying another of the active voltage and the ground voltage to the second bit line and the first control line,
   performing a second drive operation on the semiconductor circuit, the second drive operation including: bringing the first transistor and the second transistor into an OFF state; applying the ground voltage to the first control line and the second control line; and stopping power supply to the first inverter and the second inverter, and
   performing a third drive operation on the semiconductor circuit, the third drive operation including: bringing the first transistor and the second transistor into the OFF state; applying the ground voltage to the first control line and the second control line; and performing the power supply to the first inverter and the second inverter.

This application claims priority based on Japanese Patent Application No. 2023-136263 filed on August 24, 2023 with Japan Patent Office, the entire contents of which are incorporated in this application by reference.

It should be understood by those skilled in the art that various modifications, combinations, sub-combinations and alterations may occur depending on design requirements and other factors insofar as they are within the scope of the appended claims or the equivalents thereof.

## Claims

1. A semiconductor circuit comprising:
a first inverter configured to generate an inverted voltage of a voltage at a first node and configured to apply the inverted voltage to a second node;
a second inverter configured to generate an inverted voltage of a voltage at the second node and configured to apply the inverted voltage to the first node;
a first bit line and a second bit line;
a first transistor provided on a path coupling the first bit line and the first node to each other;
a second transistor provided on a path coupling the second bit line and the second node to each other;
a first control line and a second control line;
a first ferroelectric capacitor provided on a path coupling the first control line and the first node to each other;
a second ferroelectric capacitor provided on a path coupling the second control line and the second node to each other;
a third transistor including a gate, a source, and a drain, the gate being coupled to the second node;
a first signal line; and
a fourth transistor provided on a path coupling the first signal line and one of the source and the drain of the third transistor to each other.

2. The semiconductor circuit according to claim 1, further comprising
a drive section configured to: apply voltages to the first bit line, the second bit line, the first control line, and the second control line; control operations of the first transistor and the second transistor; and perform a first drive operation, a second drive operation, and a third drive operation in this order, wherein
the first drive operation includes: bringing the first transistor and the second transistor into an ON state; applying one of an active voltage and a ground voltage to the first bit line and the second control line; and applying another of the active voltage and the ground voltage to the second bit line and the first control line,
the second drive operation includes: bringing the first transistor and the second transistor into an OFF state; applying the ground voltage to the first control line and the second control line; and stopping power supply to the first inverter and the second inverter, and
the third drive operation includes: bringing the first transistor and the second transistor into the OFF state; applying the ground voltage to the first control line and the second control line; and performing the power supply to the first inverter and the second inverter.

3. The semiconductor circuit according to claim 2, further comprising
a read section coupled to the first signal line, wherein
the drive section is further configured to control an operation of the fourth transistor and configured to perform a fourth drive operation,
the fourth drive operation includes: bringing the first transistor and the second transistor into the OFF state; and bringing the fourth transistor into the ON state, and
the read section is configured to operate on a basis of a signal on the first signal line during a period when the drive section is performing the fourth drive operation.

4. The semiconductor circuit according to claim 1, wherein another of the source and the drain of the third transistor is coupled to a power supply node.

5. The semiconductor circuit according to claim 1, further comprising:
a second signal line coupled to another of the source and the drain of the third transistor; and
a signal generator configured to supply a signal to the second signal line.

6. The semiconductor circuit according to claim 5, further comprising:
a third inverter configured to generate an inverted voltage of a voltage at a third node and configured to apply the inverted voltage to a fourth node;
a fourth inverter configured to generate an inverted voltage of a voltage at the fourth node and configured to apply the inverted voltage to the third node;
a fifth transistor provided on a path coupling the first bit line and the third node to each other;
a sixth transistor provided on a path coupling the second bit line and the fourth node to each other;
a third ferroelectric capacitor provided on a path coupling the first control line and the third node to each other;
a fourth ferroelectric capacitor provided on a path coupling the second control line and the fourth node to each other;
a seventh transistor including a gate, a source, and a drain, the gate being coupled to the fourth node;
an eighth transistor provided on a path coupling the first signal line and one of the source and the drain of the seventh transistor to each other; and
a third signal line coupled to another of the source and the drain of the seventh transistor, wherein
the signal generator is configured to supply signals to the second signal line and the third signal line.

7. The semiconductor circuit according to claim 6, wherein the second signal line and the third signal line are coupled to each other.

8. The semiconductor circuit according to claim 6, wherein a size of the third transistor and a size of the seventh transistor are different from each other.

9. The semiconductor circuit according to claim 8, wherein a gate width of the third transistor and a gate width of the seventh transistor are different from each other.

10. The semiconductor circuit according to claim 6, wherein each of the third transistor and the seventh transistor comprises a tunnel field-effect transistor.

11. A drive method comprising
performing a first drive operation on a semiconductor circuit, the semiconductor circuit including: a first inverter configured to generate an inverted voltage of a voltage at a first node and configured to apply the inverted voltage to a second node; a second inverter configured to generate an inverted voltage of a voltage at the second node and configured to apply the inverted voltage to the first node; a first bit line and a second bit line; a first transistor provided on a path coupling the first bit line and the first node to each other; a second transistor provided on a path coupling the second bit line and the second node to each other; a first control line and a second control line; a first ferroelectric capacitor provided on a path coupling the first control line and the first node to each other; a second ferroelectric capacitor provided on a path coupling the second control line and the second node to each other; a third transistor including a gate, a source, and a drain, the gate being coupled to the second node; a first signal line; and a fourth transistor provided on a path coupling the first signal line and one of the source and the drain of the third transistor to each other, the first drive operation including: bringing the first transistor and the second transistor into an ON state; applying one of an active voltage and a ground voltage to the first bit line and the second control line; and applying another of the active voltage and the ground voltage to the second bit line and the first control line,
performing a second drive operation on the semiconductor circuit, the second drive operation including: bringing the first transistor and the second transistor into an OFF state; applying the ground voltage to the first control line and the second control line; and stopping power supply to the first inverter and the second inverter, and
performing a third drive operation on the semiconductor circuit, the third drive operation including: bringing the first transistor and the second transistor into the OFF state; applying the ground voltage to the first control line and the second control line; and performing the power supply to the first inverter and the second inverter.
